(19) Europäisches Patentamt
European Patent Office
Office européen des brevets

(11) EP 3 287 275 B1

(12) EUROPEAN PATENT SPECIFICATION

(45) Date of publication and mention of the grant of the patent:
**04.03.2020 Bulletin 2020/10**

(21) Application number: **17001279.3**

(22) Date of filing: **25.07.2017**

(51) Int Cl.:
***B32B 17/04*** *(2006.01)*
***C08J 5/08*** *(2006.01)*
***C08J 5/24*** *(2006.01)*
***C08L 83/04*** *(2006.01)*
***H01L 23/14*** *(2006.01)*

# (54) SILICONE RESIN TRANSPARENT SUBSTRATE AND METHOD FOR MANUFACTURING THE SAME

TRANSPARENTES SILIKONHARZSUBSTRAT UND VERFAHREN ZUR HERSTELLUNG DAVON

SUBSTRAT TRANSPARENT DE RÉSINE DE SILICONE ET SON PROCÉDÉ DE FABRICATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.08.2016 JP 2016164158**

(43) Date of publication of application:
**28.02.2018 Bulletin 2018/09**

(73) Proprietor: **Shin-Etsu Chemical Co., Ltd.
Chiyoda-ku,
Tokyo (JP)**

(72) Inventors:
- **Kimura, Saiko
Annaka-shi, Gunma-ken (JP)**
- **Hamamoto, Yoshihira
Annaka-shi, Gunma-ken (JP)**

(74) Representative: **Wibbelmann, Jobst
Wuesthoff & Wuesthoff
Patentanwälte PartG mbB
Schweigerstrasse 2
81541 München (DE)**

(56) References cited:
**EP-A1- 2 163 585**
**WO-A1-2008/103227**
**WO-A1-2012/064534**
**US-A1- 2014 120 793**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 287 275 B1

## Description

Technical Field

The present invention relates to a silicone resin transparent substrate and a method for manufacturing the same.

Background Art

Transparent substrates have been widely used for a transparent board, a transparent supporting board, an illumination, a display component, a solar cell, an organic solar cell, a flexible display, and an organic EL illumination. It has been increasing recently to use these substrates for wearable terminals. Such transparent substrates are required to have various characteristics such as, in addition to transparency, lightweight properties and flexibility, as well as higher heat resistance and lower moisture permeability.

As the transparent substrate, glass has been mainly used previously. However, the glass has disadvantages such as breakable, heavy, and hard to be thinned. Furthermore, the glass is insufficient material for recent flexible displays. Accordingly, a thin and light film-shaped substrate made of a transparent resin has been investigated as an alternative material to substitute the glass (Patent Document 1).

The film-shaped substrates made of a resin have advantages such as hard to break, easy to bend, and light, but are inferior to glass in dimensional stability and discoloration due to heat.

As a resin that excels in properties such as heat resistance and weatherability, a silicone resin is mentioned. Patent Document 2 has reported a composite of an organic silicon compound and a glass cloth developed as a transparent film using a silicone resin. The transparent film of Patent Document 2 has excellent heat resistance. In the transparent film of Patent Document 2, however, a condensation type silicone resin made of alkoxysilane is mainly used, with the resin having a small attached amount of 20% by mass or less; thus, further investigation is required to improve the flexibility, bending properties, lower moisture permeability, and productivity.

Document WO 2012/064534 discloses reinforced silicone substrates with an improved transparency based on a hydrosilylation curable silicone composition and reinforcing fibers.

Citation List

Patent Literature

Patent Document 1: Japanese Unexamined Patent Application Publication (Kokai) No. 2004-51960
Patent Document 2: Japanese Unexamined Patent Application Publication (Kokai) No. 2015-174937

Summary of Invention

Technical Problem

The present invention has been accomplished to solve the foregoing problems. It is an object of the present invention to provide a silicone resin transparent substrate that has excellent heat resistance and weatherability, together with flexibility, high transparency, and low moisture permeability; as well as a method for manufacturing the same.

Solution to Problem

To solve the problem, the present invention provides a silicone resin transparent substrate, comprising one or more than one prepreg containing a silicone resin composition contanining no filler and a fibrous base,
wherein the silicone resin transparent substrate has: an attached amount of the silicone resin composition to the fibrous base of 60% by mass or more and 99% by mass or less; a total light transmittance of 80% or more at 450 nm, as measured by a method disclosed in JIS K 7375:2008 in a thickness of 0.1 mm to 0.4 mm; and a water vapor permeability of 65 g/m$^2$·day or less, as measured by Lyssy method in conformity with JIS K 7129:2008 in a thickness of 0.1 mm to 0.4 mm.

Such a silicone resin transparent substrate has excellent heat resistance and weatherability, together with flexibility, high transparency, and low moisture permeability.

In this substrate, the silicone resin composition preferably contains:

(A) an organopolysiloxane shown by the following average composition formula (1) having two or more silicon atom-bonded alkenyl groups in one molecule,

$$(R^1_3SiO_{1/2})_a(R^1_2SiO_{2/2})_b(R^1SiO_{3/2})_c(SiO_{4/2})_d \qquad (1)$$

wherein $R^1$ independently represents a hydroxy group, a methoxy group, an ethoxy group, a saturated monovalent hydrocarbon group having 1 to 10 carbon atoms, a monovalent aromatic hydrocarbon group, or an alkenyl group having 2 to 10 carbon atoms; and "a", "b", "c", and "d" are numbers satisfying $a\geq0$, $b\geq0$, $c\geq0$, $d\geq0$, $a+b+c+d=1$, and $0<(c+d)\leq1.0$;
(B) an organohydrogenpolysiloxane having two or more silicon atom-bonded hydrogen atoms in one molecule, with the silicon atom-bonded hydrogen atoms in the component (B) being in an amount of 0.1 to 5.0 mol per one mol of the silicon atom-bonded alkenyl groups in the component (A); and
(C) a platinum group metal catalyst.

Such an addition type silicone resin composition makes the silicon resin transparent substrate be particularly excellent in heat resistance and weatherability.
It is also preferable that the silicone resin composition be in a solid state at 25°C.
Such a silicone resin composition is easy to handle, and thus is more suitable to manufacture the silicone resin transparent substrate.
It is also preferable that a difference in reflective index between the silicone resin composition and the fibrous base be 0.15 or less.
Such a silicone resin transparent substrate has higher transparency.
The present invention also provides a method for manufacturing a silicone resin transparent substrate, comprising press molding to integrate a prepreg containing a silicone resin composition containing no filler and a fibrous base or a plurality of the prepregs that are stacked,
wherein the press molding is performed by using a metal frame installed so as to surround a prepreg-laminating region for laminating the prepreg to manufacture the silicone resin transparent substrate with an attached amount of the silicone resin composition to the fibrous base being 60% by mass or more and 99% by mass or less.
Such a manufacturing method can improve the attached amount of the silicone resin composition to the fibrous base, and thus makes it possible to manufacture a silicone resin transparent substrate that has excellent heat resistance and weatherability, together with flexibility, high transparency, and low moisture permeability.
The silicone resin composition preferably contains:

(A) an organopolysiloxane shown by the following average composition formula (1) having two or more silicon atom-bonded alkenyl groups in one molecule,

$$(R^1_3SiO_{1/2})_a(R^1_2SiO_{2/2})_b(R^1SiO_{3/2})_c(SiO_{4/2})_d \qquad (1)$$

wherein $R^1$ independently represents a hydroxy group, a methoxy group, an ethoxy group, a saturated monovalent hydrocarbon group having 1 to 10 carbon atoms, a monovalent aromatic hydrocarbon group, or an alkenyl group having 2 to 10 carbon atoms; and "a", "b", "c", and "d" are numbers satisfying $a\geq0$, $b\geq0$, $c\geq0$, $d\geq0$, $a+b+c+d=1$, and $0<(c+d)\leq1.0$;
(B) an organohydrogenpolysiloxane having two or more silicon atom-bonded hydrogen atoms in one molecule, with the silicon atom-bonded hydrogen atoms in the component (B) being in an amount of 0.1 to 5.0 mol per one mol of the silicon atom-bonded alkenyl groups in the component (A); and
(C) a platinum group metal catalyst.

By using such an addition type silicone resin composition, it is possible to manufacture a silicon resin transparent substrate with good heat resistance and weatherability in good productivity.
It is preferable that the silicone resin composition be in a solid state at 25°C.
Such a silicone resin composition is easy to handle, and thus is appropriate to manufacture a silicone resin transparent substrate of the present invention.
It is also preferable that a difference in reflective index between the silicone resin composition and the fibrous base be 0.15 or less.
Such a method for manufacturing a silicone resin transparent substrate makes it possible to manufacture a silicone resin transparent substrate with higher transparency.

Advantageous Effects of Invention

As described above, the inventive silicone resin transparent substrate has excellent heat resistance and weatherability, together with flexibility, high transparency, and low moisture permeability. The inventive silicone resin transparent substrate includes a silicone resin composition, and thus is excellent in heat resistance and weatherability, compared to conventional transparent substrates. Accordingly, such a silicone resin transparent substrate of the present invention can be used for a product required to be more flexible, more transparent, and reliable.

The inventive method for manufacturing a silicone resin transparent substrate makes it possible to manufacture a silicone resin transparent substrate with high flexibility and transparency. In the inventive method for manufacturing a silicone resin transparent substrate, a silicone resin composition is used and subjected to press molding with a metal frame This increases the attached amount of the silicone resin composition to the fibrous base, thus enabling manufacture of a silicone resin transparent substrate with excellent heat resistance and weatherability in good productivity. Accordingly, when the method for manufacturing a silicone resin transparent substrate of the present invention is employed, it is possible to manufacture a silicone resin transparent substrate that can be used for a product required to be more flexible and reliable.

Brief Description of Drawings

FIG. 1 is a sectional view showing an example of a thermal press molding apparatus that can be applied to press molding in the inventive method for manufacturing a silicone resin transparent substrate;
FIG. 2 is a sectional view showing a stacked prepreg and a set of jigs when performing press molding in a method for manufacturing a silicone resin transparent substrate according to an embodiment of the present invention;
FIG. 3 is a plane view showing a stacked prepreg and a set of jigs when performing press molding in a method for manufacturing a silicone resin transparent substrate according to an embodiment of the present invention;
FIG. 4 is a schematic view showing a silicone resin transparent substrate that is held horizontally in bend test in Examples and Comparative Examples; and
FIG. 5 is a schematic view showing a silicone resin transparent substrate that is bent along a cylindrical metal bar into 180° in bend test in Examples and Comparative Examples.

Description of Embodiments

As described above, it has been required to develop a highly reliable transparent substrate that has excellent heat resistance and weatherability, together with flexibility, high transparency, and low moisture permeability.

The present inventors have diligently investigated to accomplish the foregoing object. As a result, the inventors have found that a substrate retaining a prescribed attached amount of the silicone resin and having a high total light transmittance and a low water vapor permeability, can be a highly reliable silicone resin transparent substrate that has excellent heat resistance and weatherability, together with flexibility, high transparency, and low moisture permeability, thereby completing the present invention.

That is, the present invention is a silicone resin transparent substrate, comprising one or more than one prepreg containing said silicone resin composition and a fibrous base,
wherein the silicone resin transparent substrate has: an attached amount of the silicone resin composition to the fibrous base of 60% by mass or more and 99% by mass or less; a total light transmittance of 80% or more at 450 nm, as measured by a method disclosed in JIS K 7375:2008 in a thickness of 0.1 mm to 0.4 mm; and a water vapor permeability of 65 $g/m^2 \cdot day$ or less, as measured by Lyssy method in conformity with JIS K 7129:2008 in a thickness of 0.1 mm to 0.4 mm.

Hereinafter, the present invention will be specifically described, but the present invention is not limited thereto. Herein, "Me" represents a methyl group, "Ph" represents a phenyl group, and "Vi" represents a vinyl group.

<Silicone Resin Transparent Substrate>

The inventive silicone resin transparent substrate includes one or more than one prepreg containing said silicone resin composition and a fibrous base; with the attached amount of the silicone resin composition to the fibrous base being 60% by mass or more and 99% by mass or less; the total light transmittance being 80% or more at 450 nm, as measured by a method disclosed in JIS K 7375:2008 in a thickness of 0.1 mm to 0.4 mm; and the water vapor permeability being 65 $g/m^2 \cdot day$ or less, as measured by Lyssy method in conformity with JIS K 7129:2008 in a thickness of 0.1 mm to 0.4 mm.

<Prepreg>

The inventive silicone resin transparent substrate contains one or more than one prepreg containing a silicone resin composition and a fibrous base. It is to be noted that the prepreg refers a substrate impregnated with a resin composition in uncured state.

<Fibrous Base>

The prepreg in the present invention contains a fibrous base. This fibrous base is to be impregnated with the silicone resin composition that will be described below, for example. This fibrous base is not particularly limited, and any known one can be used, including a quartz glass cloth, a glass cloth of any of E-glass, A-glass, and D-glass, and a T-glass cloth with high tensile strength. The glass cloth is in a sheet-shape, and the thickness may be appropriately selected in accordance with the use of the inventive silicone resin transparent substrate. The thickness is not particularly limited, but preferably 5 to 2,000 μm, more preferably 8 to 1,000 μm, particularly preferably 10 to 200 μm.

<Silicone Resin Composition>

The prepreg in the present invention contains a silicone resin composition. This silicone resin composition is preferably a composition (addition type silicone resin composition) that contains:

(A) an organopolysiloxane shown by the following average composition formula (1) having two or more silicon atom-bonded alkenyl groups in one molecule,

$$(R^1_3SiO_{1/2})_a(R^1_2SiO_{2/2})_b(R^1SiO_{3/2})_c(SiO_{4/2})_d \qquad (1)$$

wherein $R^1$ independently represents a hydroxy group, a methoxy group, an ethoxy group, a saturated monovalent hydrocarbon group having 1 to 10 carbon atoms, a monovalent aromatic hydrocarbon group, or an alkenyl group having 2 to 10 carbon atoms; and "a", "b", "c", and "d" are numbers satisfying $a \geq 0$, $b \geq 0$, $c \geq 0$, $d \geq 0$, $a+b+c+d=1$, and $0<(c+d)\leq 1.0$;
(B) an organohydrogenpolysiloxane having two or more silicon atom-bonded hydrogen atoms in one molecule, with the silicon atom-bonded hydrogen atoms in the component (B) being in an amount of 0.1 to 5.0 mol per one mol of the silicon atom-bonded alkenyl groups in the component (A); and
(C) a platinum group metal catalyst.

The following specifically describes each component of the foregoing silicone resin composition preferably used for the present invention.

[Component (A)]

The component (A) is an organopolysiloxane shown by the following average composition formula (1) having two or more silicon atom-bonded alkenyl groups in one molecule (i.e., unsaturated group-containing organopolysiloxane),

$$(R^1_3SiO_{1/2})_a(R^1_2SiO_{2/2})_b(R^1SiO_{3/2})_c(SiO_{4/2})_d \qquad (1)$$

wherein $R^1$ independently represents a hydroxy group, a methoxy group, an ethoxy group, a saturated monovalent hydrocarbon group having 1 to 10 carbon atoms, a monovalent aromatic hydrocarbon group, or an alkenyl group having 2 to 10 carbon atoms; and "a", "b", "c", and "d" are numbers satisfying $a \geq 0$, $b \geq 0$, $c \geq 0$, $d \geq 0$, $a+b+c+d=1$, and $0<(c+d)\leq 1.0$.

The component (A) contains either or both of the $(R^1SiO_{3/2})$ unit and the $(SiO_{4/2})$ unit. Such branched structures give a silicone resin transparent substrate with good mechanical properties.

In the average composition formula (1), $R^1$ independently represents a group selected from the group consisting of a hydroxy group, a methoxy group, an ethoxy group, a saturated monovalent hydrocarbon group having 1 to 10 carbon atoms (preferably 1 to 8 carbon atoms, more preferably 1 to 6 carbon atoms), a monovalent aromatic hydrocarbon group, and an alkenyl group having 2 to 10 carbon atoms (preferably 2 to 8 carbon atoms, more preferably 2 to 6 carbon atoms). Illustrative examples of $R^1$ include a hydroxy group; alkoxy groups such as a methoxy group and an ethoxy group; alkyl groups such as a methyl group, an ethyl group, a propyl group, an isopropyl group, a butyl group, and an isobutyl group; cycloalkyl groups such as a cyclohexyl group; aryl groups such as a phenyl group, a tolyl group, a xylyl group, and a naphthyl group; and alkenyl groups such as a vinyl group, a propenyl group, and an isopropenyl group. Among them, a methyl group, a phenyl group, and a vinyl group are particularly preferable.

Illustrative examples of the component (A) include the following organopolysiloxanes having the $(R^1_3SiO_{1/2})$ unit, the $(R^1_2SiO_{2/2})$ unit, and the $(R^1SiO_{3/2})$ unit:

$(Me_2ViSiO_{1/2})_{a1}(Me_2SiO_{2/2})_{b1}(PhSiO_{3/2})_{c1}$

$(Me_2ViSiO_{1/2})_{a2}(MeViSiO_{2/2})_{b2}(PhSiO_{3/2})_{c2}$

$(Me_2ViSiO_{1/2})_{a3}(MePhSiO_{2/2})_{b3}(PhSiO_{3/2})_{c3}$

$(Me_2ViSiO_{1/2})_{a4}(Ph_2SiO_{2/2})_{b4}(PhSiO_{3/2})_{c4}$

$(Me_2ViSiO_{1/2})_{a5}(Ph_2SiO_{2/2})_{b5}(MeSiO_{3/2})_{c5}$

$(Me_2ViSiO_{1/2})_{a6}(Me_2SiO_{2/2})_{b6}(MeViSiO_{2/2})_{b7}(PhSiO_{3/2})_{c6}$

$(Me_2ViSiO_{1/2})_{a7}(MePhSiO_{2/2})_{b8}(MeViSiO_{2/2})_{b9}(PhSiO_{3/2})_{c7}$

$(MeVi_2SiO_{1/2})_{a8}(Me_2SiO_{2/2})_{b10}(PhSiO_{3/2})_{c8}$

$(MeVi_2SiO_{1/2})_{a9}(MePh_2SiO_{1/2})_{a10}(MePhSiO_{2/2})_{b11}(MeSiO_{3/2})_{c9}$

wherein a1, a2, a3, a4, a5, a6, a7, a8, a9, a10, b1, b2, b3, b4, b5, b6, b7, b8, b9, b10, b11, c1, c2, c3, c4, c5, c6, c7, c8, and c9 are numbers satisfying 0.01≤a1≤0.6, 0.01≤a2≤0.6, 0.01≤a3≤0.6, 0.01≤a4≤0.6, 0.01≤a5≤0.6, 0.01≤a6≤0.2, 0.01≤a7≤0.2, 0.01≤a8≤0.6, 0.01≤a9≤0.2, 0.01≤a10≤0.2, 0.005≤b1≤0.5, 0.005≤b2≤0.5, 0.005≤b3≤0.5, 0.005≤b4≤0.5, 0.005≤b5≤0.5, 0.2≤b6≤0.7, 0.01≤b7≤0.2, 0.2≤b8≤0.7, 0.01≤b9≤0.2, 0.005≤b10≤0.5, 0.4≤b11≤0.9, 0.24≤c1≤0.9, 0.24≤c2≤0.9, 0.24≤c3≤0.9, 0.24≤c4≤0.9, 0.24≤c5≤0.9., 0.2≤c6≤0.7, 0.2≤c7≤0.7, 0.24≤c8≤0.9, and 0.01≤c9≤0.2, a1+b1+c1=1, a2+b2+c2=1, a3+b3+c3=1, a4+b4+c4=1, a5+b5+c5=1, a6+b6+b7+c6=1, a7+b8+b9+c7=1, a8+b10+c8=1, and a9+a10+b11+c9=1.

Illustrative examples of the component (A) also include the following organopolysiloxanes having the $(R^1SiO_{3/2})$ unit alone:

$(PhSiO_{3/2})_{c10}(ViSiO_{3/2})_{c11}$

$(MeSiO_{3/2})_{c12}(ViSiO_{3/2})_{c13}$

wherein c10, c11, c12, and c13 are numbers satisfying 0.5≤c10≤0.95, 0.05≤c11≤0.5, 0.5≤c12≤0.98, 0.02≤c13≤0.5, c10+c11=1, and c12+c13=1.

Illustrative examples of the component (A) also include the following organopolysiloxanes having the $(R^1_3SiO_{1/2})$ unit, the $(R^1_2SiO_{2/2})$unit, and the $(SiO_{4/2})$ unit:

$(Me_2ViSiO_{1/2})_{a11}(Ph_2SiO_{2/2})_{b12}(SiO_{4/2})_{d1}$

$(Me_3SiO_{1/2})_{a12}(Me_2ViSiO_{1/2})_{a13}(MePhSiO_{2/2})_{b13}(MeViSiO_{2/2})_{b14}(Ph_2SiO_{2/2})_{b15}(SiO_{4/2})_{d2}$

wherein a11, a12, a13, b12, b13, b14, b15, d1, and d2 are numbers satisfying 0.1≤a11≤0.7, 0.02≤a12≤0.3, 0.05≤a13≤0.4, 0.1≤b12≤0.2, 0.02≤b13≤0.3, 0.005≤b14≤0.1, 0.1≤b15≤0.5, 0.1≤d1≤0.7, and 0.1≤d2≤0.6, a11+b12+d1=1, and a12+a13+b13+b14+b15+d2=1.

Illustrative examples of the component (A) also include the following unsaturated group-containing organopolysiloxanes having the $(R^1_3SiO_{1/2})$ unit and the $(SiO_{4/2})$unit:

$(Me_2ViSiO_{1/2})a14(SiO_{4/2})_{d3}$

$(Me_3SiO_{1/2})_{a15}(Me_2ViSiO_{1/2})_{a16}(SiO_{4/2})_{d4}$

$(Me_3SiO_{1/2})_{a17}(MePhViSiO_{1/2})_{a18}(SiO_{4/2})_{d5}$

wherein a14, a15, a16, a17, a18, d3, d4, and d5 are numbers satisfying 0.01≤a14≤0.5, 0.1≤a15≤0.5, 0.05≤a16≤0.3, 0.1≤a17≤0.5, 0.05≤a18≤0.3, 0.5≤d3≤0.99, 0.3≤d4≤0.85, and 0.3≤d5≤0.85, a14+d3=1, a15+a16+d4=1, and

a17+a18+d5=1.

The organopolysiloxane of the component (A) is not limited to the foregoing examples. The foregoing organopolysiloxane can be used singly or in combination of two or more kinds as the component (A).

The weight-average molecular weight of the component (A) is preferably in a range of 1,000 to 1,000,000 in terms of polystyrene. The component (A) is preferably in a solid state or a semisolid state at room temperature in view of the workability and the curability.

Herein, weight-average molecular weight refers a weight-average molecular weight measured by gel permeation chromatography (GPC) under the following conditions using polystyrene as a standard substance.

[Measurement Conditions]

Eluent: tetrahydrofuran (THF)
Flow rate: 0.6 mL/min
Detector: Differential refractive index detector (RI)
Column: TSK Guardcolomn Super H-L
TSK gel Super H4000 (6.0 mm I.D. × 15 cm × 1)
TSK gel Super H3000 (6.0 mm I.D. × 15 cm × 1)
TSK gel Super H2000 (6.0 mm I.D. × 15 cm × 2)

(Products from Tosoh Corporation)

Column temperature: 40°C
Sample injection amount: 20 μL (a THF solution with a concentration of 0.5% by weight)

The organopolysiloxane of the component (A) can be synthesized by combining raw material compounds of each unit in such a way that the produced polymer contains the siloxane units in a desired mole ratio, followed by co-hydrolysis condensation in the presence of an acid, for example.

Illustrative examples of the raw material of each siloxane unit include chlorosilanes corresponding to each siloxane unit; and alkoxysilanes such as methoxysilanes, corresponding to each of these chlorosilanes.

[Component (B)]

The component (B) is an organohydrogenpolysiloxane having two or more silicon atom-bonded hydrogen atoms (hereinafter, referred to as an "SiH group") in one molecule, which functions as a crosslinking agent of the component (A) described above.

Illustrative examples of the component (B) include the following organohydrogenpolysiloxane:

$$(Me_2HSiO_{1/2})_{e1}(Me_2SiO_{2/2})_{f1}(PhSiO_{3/2})_{g1}$$

$$(Me_2HSiO_{1/2})_{e2}(Me_2SiO_{2/2})_{f2}(MeHSiO_{2/2})_{f3}(PhSiO_{3/2})_{g2}$$

$$(Me_2HSiO_{1/2})_{e3}(PhSiO_{3/2})_{g3}$$

$$(Me_2HSiO_{1/2})_{e4}(MeSiO_{3/2})_{g4}$$

$$(MeHSiO_{2/2})_{f4}(PhSiO_{3/2})_{g5}$$

$$(MeHSiO_{2/2})_{f5}(MeSiO_{3/2})_{g6}$$

$$(MeHSiO_{2/2})_{f6}(Me_2SiO_{2/2})_{f7}(PhSiO_{3/2})_{g7}$$

$$(MeHSiO_{2/2})_{f8}(MePhSiO_{2/2})_{f9}(PhSiO_{3/2})_{g8}$$

$$(Me_2HSiO_{1/2})_{c5}(Ph_2SiO_{2/2})_{f10}$$

$$(Me_2HSiO_{1/2})_{e6}(Me_2SiO_{2/2})_{f11}$$

$$(Me_3SiO_{1/2})_{e7}(MeHSiO_{2/2})_{f12}$$

$$(Me_3SiO_{1/2})_{e8}(MeHSiO_{2/2})_{f13}(Ph_2SiO_{2/2})_{f14}$$

$$(Me_3SiO_{1/2})_{e9}(MeHSiO_{2/2})_{f15}(Me_2SiO_{2/2})_{f16}$$

wherein e1, e2, e3, e4, e5, e6, e7, e8, e9, f1, f2, f3, f4, f5, f6, f7, f8, f9, f10, f11, f12, f13, f14, f15, f16, g1, g2, g3, g4, g5, g6, g7, and g8 are numbers satisfying $0.01 \le e1 \le 0.5$, $0.01 \le e2 \le 0.5$, $0.3 \le e3 \le 0.9$, $0.01 \le e4 \le 0.9$, $0.3 \le e5 \le 0.9$, $0.05 \le e6 \le 0.7$, $0.1 \le e7 \le 0.7$, $0.01 \le e8 \le 0.2$, $0.01 \le e9 \le 0.3$, $0.09 \le f1 \le 0.75$, $0.045 \le f2 \le 0.7$, $0.045 \le f3 \le 0.7$, $0.05 \le f4 \le 0.5$, $0.05 \le f5 \le 0.5$, $0.01 \le f6 \le 0.2$, $0.2 \le f7 \le 0.8$, $0.01 \le f8 \le 0.2$, $0.2 \le f9 \le 0.8$, $0.1 \le f10 \le 0.7$, $0.3 \le f11 \le 0.95$, $0.3 \le f12 \le 0.9$, $0.3 \le f13 \le 0.9$, $0.05 \le f14 \le 0.5$, $0.1 \le f15 \le 0.6$, $0.3 \le f16 \le 0.8$, $0.24 \le g1 \le 0.9$, $0.24 \le g2 \le 0.9$, $0.1 \le g3 \le 0.7$, $0.1 \le g4 \le 0.99$, $0.5 \le g5 \le 0.95$, $0.5 \le g6 \le 0.95$, $0.1 \le g7 \le 0.7$, and $0.1 \le g8 \le 0.7$, $e1+f1+g1=1$, $e2+f2+f3+g2=1$, $e3+g3=1$, $e4+g4=1$, $f4+g5=1$, $f5+g6=1$, $f6+f7+g7=1$, $f8+f9+g8=1$, $e5+f10=1$, $e6+f11=1$, $e7+f12=1$, $e8+f13+f14=1$, and $e9+f15+f16=1$.

The organohydrogenpolysiloxane of the component (B) is not limited to the foregoing examples. The foregoing organohydrogenpolysiloxane can be used singly or in combination of two or more kinds as the component (B).

The formulation amount of the component (B) is such that the amount of the silicon atom-bonded hydrogen atoms (SiH groups) in the component (B) is 0.1 to 5.0 mol, preferably 0.1 to 4.0 mol, more preferably 0.5 to 3.0 mol, particularly preferably 0.8 to 2.0 mol per one mol of the silicon atom-bonded alkenyl groups in the component (A). When the amount is 0.1 mol or more, it is possible to proceed the curing reaction sufficiently to give a cured product easily. When the amount is 5.0 mol or less, the cured product does not cause a risk of leaving a large amount of unreacted SiH groups, and thus properties of the cured product are prevented from changing over time.

The weight-average molecular weight of the component (B) is preferably in a range of 100 to 1,000,000 in terms of polystyrene.

The organopolysiloxane of the component (B) can be synthesized by combining raw material compounds of each unit in such a way that the product polymer contains the siloxane units in a desired mole ratio, followed by co-hydrolysis condensation in the presence of an acid, for example.

Illustrative examples of the raw material of each siloxane unit include chlorosilanes corresponding to each siloxane unit; and alkoxysilanes such as methoxysilanes, corresponding to each of these chlorosilanes.

In the present invention, either or both of the component (A) and the component (B) preferably contain a silanol group to give adhesiveness. In this case, the amount of siloxane units containing silanol groups is preferably about 40 mol% or less (0 to 40 mol%) based on the whole siloxane unit.

[Component (C)]

The component (C) is a platinum group metal catalyst. This component is formulated to cause addition curing reaction of the silicone resin composition.

The catalyst used as the component (C) may be any previously known platinum group metal catalyst that can promote hydrosilylation reaction. Illustrative examples of the component (C) include platinum type catalysts such as platinum, platinum black, chloroplatinic acid, for example, $H_2PtCl_6 \cdot pH_2O$, $K_2PtCl_6$, $KHPtCl_6 \cdot pH_2O$, $K_2PtCl_4$, $K_2PtCl_4 \cdot pH_2O$, $PtO_2 \cdot pH_2O$, $PtCl_4 \cdot pH_2O$, $PtCl_2$, $H_2PtCl_4 \cdot pH_2O$ (wherein "p" represents a positive integer); and a complex of the above with a hydrocarbon such as an olefin, an alcohol, or a vinyl group-containing organopolysiloxane. The foregoing catalyst can be used singly or in combination of two or more kinds as the component (C).

The formulation amount of the component (C) may be an effective amount for curing, normally in a range of 0.1 to 500 ppm, particularly 0.5 to 100 ppm in terms of a mass of the platinum group metal based on the total amount of the component (A) and the component (B). The silicone resin transparent substrate can be obtained in a good productivity by formulating the component (C) in the foregoing range.

[Other Components]

In the silicone resin composition, various types of additives can be formulated in accordance with needs, along with the components (A), (B), and (C) described above. Any known ones can be used as the additives.

(Adhesion Assistant)

The silicone resin composition may contain an adhesion assistant (an adhesiveness provider) in accordance with needs to give adhesiveness. Illustrative examples of the adhesion assistant include a linear or cyclic organosiloxane oligomers having 4 to 50 silicon atoms, preferably about 4 to 20 silicon atoms, and having at least two kinds, preferably two or three kinds of functional groups selected from a silicon atom-bonded hydrogen atom (an SiH group), silicon atom-bonded alkenyl groups (e.g., an $Si\text{-}CH=CH_2$ group), alkoxysilyl groups (e.g., a trimethoxysilyl group), and epoxy groups (e.g., glycidoxypropyl group, 3,4-epoxycyclohexylethyl group) in one molecule; organooxysilyl-modified isocyanurate

compounds shown by the following formula (2); and hydrolysis condensates thereof (organosiloxane-modified isocyanurate compounds). The adhesion assistants may be used singly or in combination of two or more kinds.

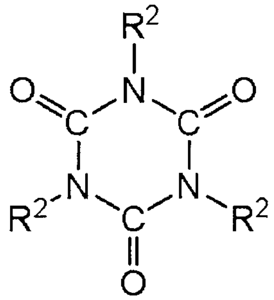

(2)

In the formula, $R^2$ is an organic group shown by the following formula (3) or a monovalent hydrocarbon group containing an aliphatic unsaturated bond, and one or more of $R^2$ are the organic group shown by the formula (3).

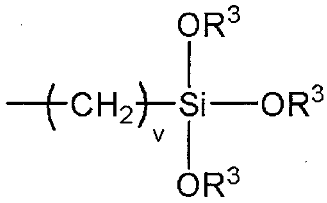

(3)

wherein $R^3$ is a hydrogen atom or a monovalent hydrocarbon group having 1 to 8 carbon atoms; and "v" is an integer of 1 to 6, preferably 1 to 4.

Illustrative examples of the monovalent hydrocarbon group containing an aliphatic unsaturated bond of $R^2$ in the formula (2) include alkenyl groups having 2 to 8 carbon atoms, preferably 2 to 6 carbon atoms such as a vinyl group, an allyl group, a propenyl group, an isopropenyl group, a butenyl group, an isobutenyl group, a pentenyl group, and a hexenyl group; and cycloalkenyl groups having 6 to 8 carbon atoms such as a cyclohexenyl group.

Illustrative examples of the monovalent hydrocarbon group of $R^3$ in the formula (3) include monovalent hydrocarbon groups having 1 to 8 carbon atoms, preferably 1 to 6 carbon atoms such as alkyl groups including a methyl group, an ethyl group, a propyl group, an isopropyl group, a butyl group, an isobutyl group, a tert-butyl group, a pentyl group, and a hexyl group; cycloalkyl groups including a cyclohexyl group; the alkenyl groups and the cycloalkenyl groups illustrated as examples of $R^2$; and an aryl group including a phenyl group. Among them, alkyl groups are preferable.

Illustrative examples of the adhesion assistant further include 1,5-bis(glycidoxypropyl)-1,3,5,7-tetramethylcyclotetrasiloxane, 1-glycydoxypropyl-5-trimethoxysilylethyl-1,3,5,7-tetramethylcyclotetrasiloxane, and compounds shown by the following formulae.

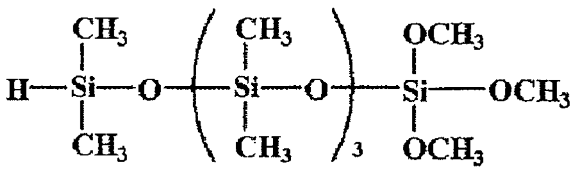

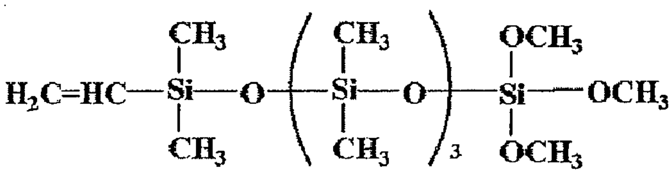

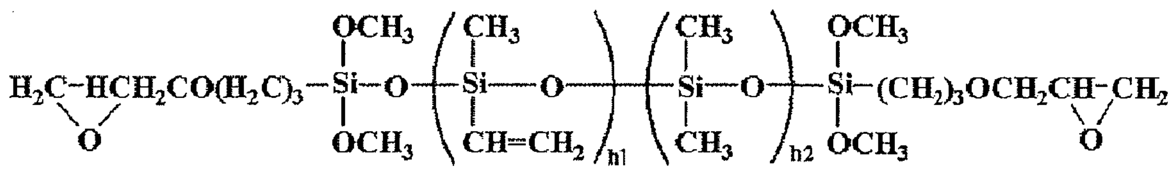

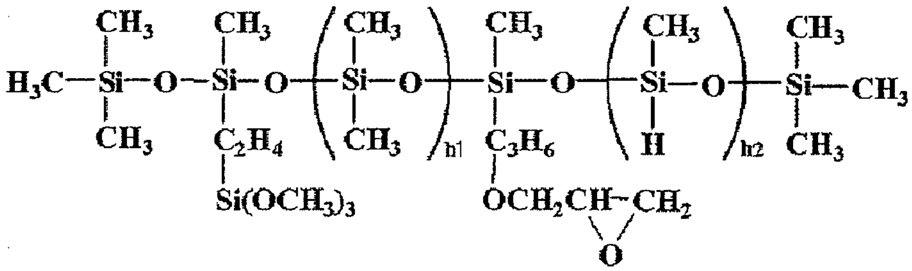

In the formulae, h1 and h2 are each an integer of 0 to 50 satisfying that h1+h2 is 2 to 50, preferably 4 to 20.

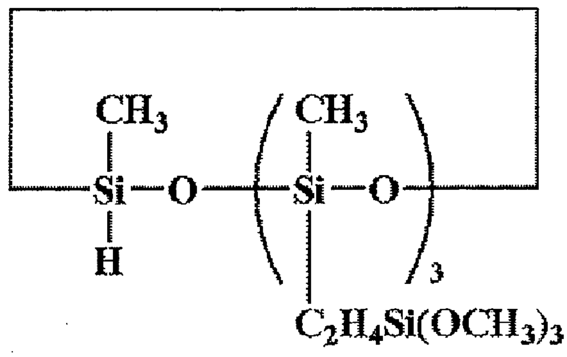

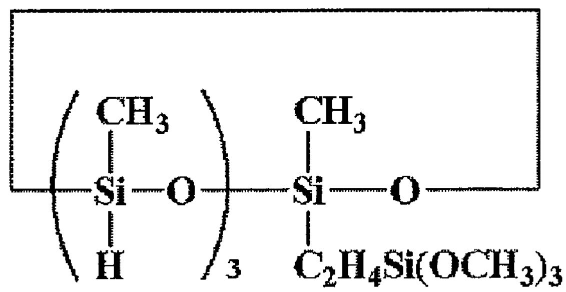

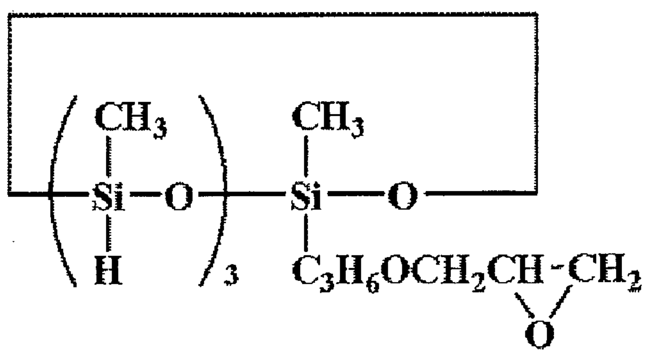

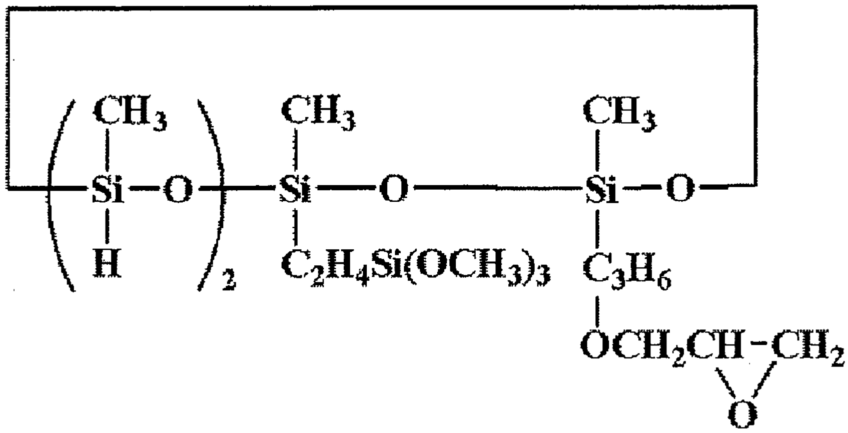

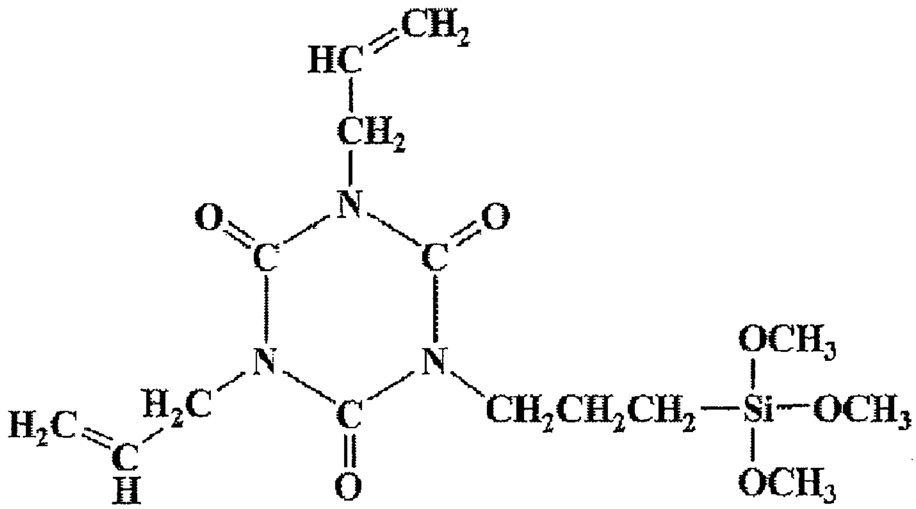

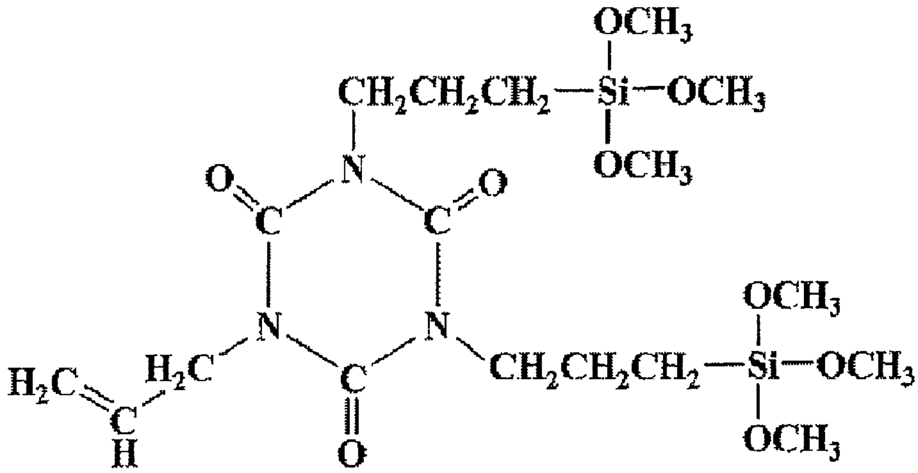

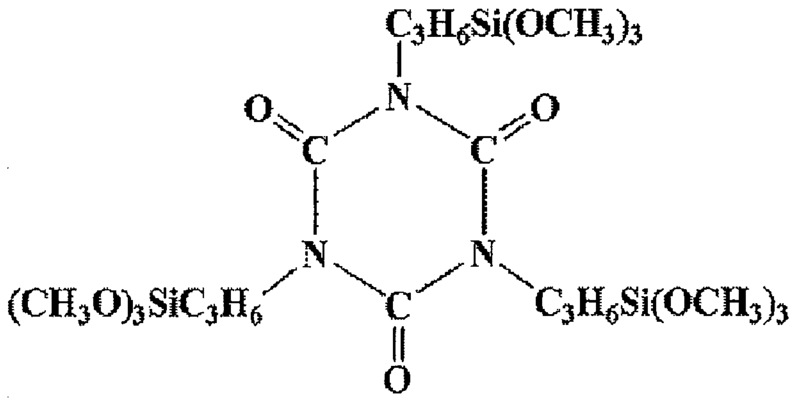

Among the foregoing adhesion assistants, the organosilicon compound having a silicon atom-bonded alkoxy group and an alkenyl group or a silicon atom-bonded hydrogen atom (a SiH group) in one molecule gives a cured product of the silicone resin composition with particularly favorable adhesiveness.

The formulation amount of the adhesion assistant is normally about 10 parts by mass or less (i.e., 0 to 10 parts by mass), preferably about 0.1 to 8 parts by mass, and more preferably about 0.2 to 5 parts by mass based on 100 parts by mass of the component (A). The adhesion assistant in amount of 10 parts by mass or less is not liable to affect the hardness of the cured silicon resin composition nor increase the surface tackiness.

(Curing inhibitor)

The silicone resin composition may contain a curing inhibitor in accordance with needs. Illustrative examples of the curing inhibitor include organopolysiloxanes containing vinyl groups in high content such as 1,3,5,7-tetramethyl-1,3,5,7-tetravinylcyclotetrasiloxane, triallylisocyanurates, alkylmaleates, acetylene alcohols; silane modified compounds thereof, siloxane-modified compounds thereof; hydroperoxide, tetramethylethylenediamine, and benzotriazole. The curing inhibitor may be used singly or in combination of two or more kinds.

The formulation amount of the curing inhibitor is normally 0.001 to 1.0 parts by mass, and preferably 0.005 to 0.5 parts by mass based on 100 parts by mass of the component (A).

The silicone resin composition in the present invention is preferably in a solid state at 25°C (room temperature), more preferably in a plastic solid state at 25°C (room temperature). Such a silicone resin composition is easy to handle, and thus is suitable in view of workability for manufacturing a silicone resin transparent substrate.

In the present invention, the difference in reflective index between the silicone resin composition and the fibrous base is preferably 0.15 or less, more preferably 0.08 or less, particularly preferably 0.06 or less. The silicone resin transparent substrate can achieve good transmittance when the difference is in the foregoing range.

(Method for Preparing Silicone Resin Composition)

The foregoing addition type silicone resin composition can be prepared by mixing required components homogeneously. Normally, the composition is separated into two packages so as not to cure in storing, and the two packages of liquid are mixed to perform curing when used. Alternatively, the composition may be used as a one package composition by adding a small amount of the curing inhibitor, such as acetylene alcohol. The addition type silicone resin composition may be mixed with an additive in accordance with needs after obtaining a base composition by mixing the components (A), (B), and (C) homogeneously. This base composition may be prepared as a solution or a dispersion by adding a solvent in accordance with needs.

This solvent is not particularly limited, and any solvent that can dissolve or disperse the silicone resin composition may be used. Illustrative examples of such a solvent include non-polar hydrocarbon solvents such as toluene, xylene, hexane, and heptane; and ethers. Among them, toluene and xylene are preferable.

The amount of the solvent is not particularly limited as long as the silicone resin composition can be dissolved or dispersed to impregnate a fibrous base (e.g., glass cloth) with the obtained solution or dispersion. The amount is preferably 5 parts by mass or more and 200 parts by mass or less, more preferably 10 parts by mass or more and 100 parts by mass or less based on 100 parts by mass of the silicone resin composition.

<Metal Layer>

The inventive silicone resin transparent substrate may have a metal layer(s) on one surface or both surfaces

of the silicone resin transparent substrate. The silicone resin transparent substrate having such a metal layer is more suitable for a semiconductor apparatus or a package substrate.

The metal layer formed on one surface or both surfaces of the silicone resin transparent substrate is not particularly limited. The layer preferably contains a metal selected from Ni, Cu, Fe, Co, or alloy composed of two or more of these metals such as Ni-Cu alloy, Fe-Ni alloy, or Fe-Co alloy, for example.

The metal layer can be formed by a method of subjecting a cured silicone resin transparent substrate to a physical vapor deposition method such as a subtractive method, an electroless plating method, an electrolytic plating method, a vacuum deposition method and a sputtering method; a method of applying a coating composition containing a metal filler; a method of dipping a silicone resin transparent substrate to this coating composition; or a method in which a metal foil(s), a metal plate(s), or a metal mesh(es) is disposed on one surface or both surfaces of a sheet-shape silicone resin composition before curing the silicone resin composition, followed by press molding by the inventive manufacturing method that will be described later; but is not limited thereto. Such methods makes it possible to easily manufacture a silicone resin transparent substrate having a metal layer(s) formed on one surface or both surfaces.

The outmost layer of the obtained silicone resin transparent substrate, having the metal layer formed thereon, may be subjected to patterning and metal plating in accordance with needs. The metal plating can be performed by a conventional method, and the method is not particularly limited. This metal layer formed by metal plating preferably contains a metal selected from Ni, Pd, Au, Ag, Sn, or alloys composed of two or more of these metals such as Ni-Au alloy, Ni-Ag alloy, or Ni-Pd-Au alloy, for example. It is also possible to perform electrolytic plating subsequent to electroless plating to increase the formed metal layer.

- Attached Amount of Silicone Resin Composition -

In the inventive silicone resin transparent substrate, the attached amount of the silicone resin composition to the fibrous base is 60% by mass or more and 99% by mass or less. The attached amount of the silicone resin composition to the fibrous base is preferably 75% by mass or more and 99% by mass or less, more preferably 85% by mass or more and 99% by mass or less, most preferably more than 90% by mass and 99% by mass or less. The attached amount of 60% by mass or more and 99% by mass or less have to be retained to obtain a transparent substrate that has flexibility, high transparency, and low moisture permeability.

Herein, the attached amount of the silicone resin composition to the fibrous base is expressed as a difference between the weight of the fibrous base (e.g., glass cloth) and the weight of the silicone resin transparent substrate after press molding. Specifically, the attached amount of the silicone resin composition to the fibrous base is determined by the following numerical formula 1.

$$\text{Attached amount of silicone resin composition to fibrous base (mass\%)} = ((\text{mass of silicone resin transparent substrate (g)} - \text{mass of fibrous base (g)})/\text{mass of silicone resin transparent substrate (g)}) \times 100 \quad \text{(Numerical Formula 1)}$$

- Total Light Transmittance -

The inventive silicone resin transparent substrate is characterized in that the total light transmittance is 80% or more at 450 nm, as measured by a method disclosed in JIS K 7375:2008 in a thickness of 0.1 mm to 0.4 mm. The total light transmittance at 450 nm is preferably 85% or more, more preferably 88% or more. When the total light transmittance at 450 nm is less than 80%, the silicone resin transparent substrate is inappropriate for a material that is required to have high transparency.

The total light transmittance can be measured by the method disclosed in JIS K 7375:2008 on the silicone resin transparent substrate with a thickness of 0.1 mm to 0.4 mm by using a calibrated spectrophotometer and an integrating sphere.

- Water Vapor Permeability -

The inventive silicone resin transparent substrate is characterized in that the water vapor permeability is 65 $g/m^2 \cdot day$ or less, as measured by Lyssy method in conformity with JIS K 7129:2008 in a thickness of 0.1 mm to 0.4 mm.

The water vapor permeability is preferably 55 $g/m^2 \cdot day$ or less, more preferably 50 $g/m^2 \cdot day$ or less. The silicone resin transparent substrate with a water vapor permeability of more than 65 $g/m^2 \cdot day$ largely affects electronic parts to be mounted when used under severe conditions, thus failing to provide a highly reliable substrate.

As described above, the inventive silicone resin transparent substrate has excellent heat resistance and weatherability, together with flexibility, high transparency, and low moisture permeability. The inventive silicone resin transparent substrate, which includes the silicone resin composition, is excellent in heat resistance and weatherability compared to conventional transparent substrates. Accordingly, such a silicone resin transparent substrate of the present invention can be used for a product required to have high flexibility and transparency as well as reliability.

(Method for Manufacturing Silicone Resin Transparent Substrate)

The present invention also provides a method for manufacturing a silicone resin transparent substrate, comprising press molding to integrate a prepreg containing a silicone resin composition and a fibrous base or a plurality of the prepregs that are stacked,
wherein the press molding is performed by using a metal frame installed so as to surround a prepreg-laminating region for laminating the prepreg to manufacture the silicone resin transparent substrate with an attached amount of the silicone resin composition to the fibrous base being 60% by mass or more and 99% by mass or less. Hereinafter, the inventive method for manufacturing a silicone resin transparent substrate will be described more specifically.

- Production of Prepreg -

The inventive method for manufacturing a silicone resin transparent substrate begins with production of a prepreg that contains a silicone resin composition appropriately prepared by the foregoing preparation method and a fibrous base. The prepreg can be produced by a conventional method of applying a resin composition to a fibrous base. The application method can be performed by using a representative system such as a direct gravure coater, a chamber doctor coater, an offset gravure coater, a roll kiss coater, a reverse kiss coater, a bar coater, a reverse roll coater, a slot die, an air doctor coater, a normal rotation roll coater, a blade coater, a knife coater, an impregnation coater, an MB coater, and an MB reverse coater. Among them, the system using a direct gravure coater, an offset coater, or an impregnation coater is preferable, and an impregnation coater is more preferable.

When the silicone resin composition contains a volatile component such as a solvent, the volatile component is preferably evaporated by drying the prepreg in accordance with needs after applying the silicone resin composition. The volatile component can be evaporated from a glass cloth impregnated with a silicone resin composition dissolved or dispersed into a solvent, for example, by leaving it at 50°C or more and 200°C or less, more preferably 60°C or more and 150°C or less. It is also possible to use a heating apparatus such as an oven or a drier appropriately.

Examples of the silicone resin composition preferably used for the inventive method of manufacturing a silicone resin transparent substrate include the silicone resin composition described above that contains:

(A) an organopolysiloxane shown by the following average composition formula (1) having two or more silicon atom-bonded alkenyl groups in one molecule,

$$(R^1{}_3SiO_{1/2})_a(R^1{}_2SiO_{2/2})_b(R^1SiO_{3/2})_c(SiO_{4/2})_d \qquad (1)$$

wherein $R^1$ independently represents a hydroxy group, a methoxy group, an ethoxy group, a saturated monovalent hydrocarbon group having 1 to 10 carbon atoms, a monovalent aromatic hydrocarbon group, or an alkenyl group having 2 to 10 carbon atoms; and "a", "b", "c", and "d" are numbers satisfying $a \geq 0$, $b \geq 0$, $c \geq 0$, $d \geq 0$, $a+b+c+d=1$, and $0<(c+d) \leq 1.0$;
(B) an organohydrogenpolysiloxane having two or more silicon atom-bonded hydrogen atoms in one molecule, with the silicon atom-bonded hydrogen atoms in the component (B) being in an amount of 0.1 to 5.0 mol per one mol of the silicon atom-bonded alkenyl groups in the component (A); and
(C) a platinum group metal catalyst.

It is preferable to use a silicone resin composition that is in a solid state at 25°C.

It is also preferable to use a silicone resin composition and a fibrous base in which the difference in reflective index between the silicone resin composition and the fibrous base is 0.15 or less.

- Stacking of Prepreg -

Then, the obtained prepregs may be stacked. It is possible to use only one sheet of the prepreg produced as

described above, or to stack a plurality of the prepregs in accordance with needs.

It is also possible to provide an adhesive layer composed of an adhesive resin composition between the prepregs in accordance with needs. In this adhesive resin composition, a thermosetting resin is preferably used. Such a silicone resin transparent substrate, which contains a thermosetting resin as the adhesive layer, has excellent heat resistance and discoloration resistance.

The thermosetting resin used as the adhesive layer may be any known thermosetting resin that has adhesive properties. Illustrative examples thereof include silicone resin, epoxy resin, and phenol resin. In view of retaining the transparency of the substrate, silicone resin is preferable.

The adhesive layer can be applied by the same coating systems described in the production of prepreg. Among them, coating system using a direct gravure coater or an impregnation coater is preferable. It is also possible to place an adhesive layer that has been formed in a sheet-shape previously between the prepregs.

Tn the present invention, adhesion between the prepreg and the adhesive layer may be further improved by subjecting either or both of the prepreg and the adhesive layer to treatment for improving the adhesion. Illustrative examples of the treatment for improving the adhesion include discharge treatment such as atmospheric plasma treatment, corona discharge treatment, and low temperature plasma treatment; surface swelling treatment with alkali, desmearing treatment with permanganic acid, primer treatment with a silane coupling agent.

- Press Molding -

Subsequently, the stacked prepreg is integrated by press molding. In the inventive method for manufacturing a silicone resin transparent substrate, the press molding can be performed by a thermal press apparatus normally used for molding substrates. FIG. 1 is a sectional view showing an example of a thermal press molding apparatus that can be applied to press molding in the inventive method for manufacturing a silicone resin transparent substrate. As shown in FIG. 1, the thermal press molding apparatus 1 is provided with a pair of an upper press-heating plate 2 and a lower press-heating plate 3 disposed at upper and lower portions respectively. On the lower side of the upper press-heating plate 2 and the upper side of the lower press-heating plate 3, a cushion 4 and a cushion 5 are disposed respectively.

The inventive method for manufacturing a silicone resin transparent substrate is characterized in that the press molding is performed by using a metal frame installed so as to surround a prepreg-laminating region for laminating the prepreg to manufacture a silicone resin transparent substrate with an attached amount of the silicone resin composition to the fibrous base of 60% by mass or more and 99% by mass or less. FIG. 2 is a sectional view showing an example of a stacked prepreg and a set of jigs when performing press molding in the inventive method for manufacturing a silicone resin transparent substrate. FIG. 3 is a plane view showing an example of a stacked prepreg and a set of jigs when performing press molding in the inventive method for manufacturing a silicone resin transparent substrate. As shown in FIG. 2 and FIG. 3, the press molding is performed by using a jig 11 composed of an upper metal plate 6, a lower metal plate 7, release sheets 8 and 9, and a metal frame 10 in the inventive method for manufacturing a silicone resin transparent substrate. In the jig 11, the release sheet 9 is disposed on the upper side of the lower metal plate 7, and a stacked prepreg 13, which may have been obtained by stacking the prepregs as described above, is disposed on a prepreg-laminating region 12 at the upper side of the release sheet 9. In the present invention, the metal frame 10 is installed so as to surround the prepreg-laminating region. On the upper side of the metal frame 10 and the stacked prepreg 13, the release sheet 8 and the upper metal plate 6 are disposed.

The (stacked) prepreg 13 and the set of the jigs 11 shown in FIG. 2 are arranged between the cushions 4 and 5 of the thermal press molding apparatus shown in FIG. 1 to perform press molding. In the inventive manufacturing method, the metal frame 10 can prevent the silicone resin composition from flowing due to excess pressing of the (stacked) prepreg 13 during molding with the thermal press molding apparatus 1, thereby making it possible to retain the attached amount of the silicone resin composition larger.

By retaining the attached amount of the silicone resin composition larger, it is possible to bring out properties of the silicone resin such as good heat resistance, weatherability, and flexibility in the silicone resin transparent substrate. When the attached amount of the silicone resin composition is less than 60% by mass, it is impossible to manufacture a silicone resin transparent substrate with high transparency and low moisture permeability.

The press molding in the present invention can be performed under the following conditions: the pressure is preferably 1 to 100 MPa, more preferably 5 to 50 MPa; the temperature is preferably 50 to 200°C, more preferably 70 to 180°C. The curing time is preferably 1 to 200 minutes, more preferably 2 to 120 minutes. Post-cure may be performed in accordance with needs.

The press molding in the present invention allows to mold a plurality of the silicon resin transparent substrates simultaneously by stacking multiple pairs of the stacked prepreg and the jig shown in FIG. 2 and placing them to a thermal press molding apparatus.

The cushions 4 and 5 may be YOM top boards manufactured by Yamauchi Corporation or RA boards manufactured by MITSUBISHI PAPER MILLS LIMITED. The upper metal plate 6 and the lower metal plate 7 may be made

of SUS with a thickness of 1 mm or more. The release sheets 8 and 9 may be made of a fluorinated resin, for example, a PTFE resin film (trade name: Teflon (registered trade mark), manufactured by E. I. du Pont de Nemours and Company) or an ETFE resin film (trade name: AFLEX, manufactured by ASAHI GLASS Co., Ltd.). The metal frame 10 may be made of SUS with the thickness being appropriately adjusted, for example. The thickness of the metal frame may be adjusted such that the attached amount of silicone resin composition is 60% by mass or more and 99% by mass or less after press molding.

As described above, the inventive method for manufacturing a silicone resin transparent substrate enables the attached amount of the silicone resin composition to the fibrous base to be retained larger, thereby making it possible to manufacture a silicone resin transparent substrate with high flexibility and transparency. The inventive method for manufacturing a silicone resin transparent substrate uses a silicone resin composition and performs press molding by using a metal frame, thereby making it possible to manufacture a silicone resin transparent substrate that has a large amount of the silicone resin composition attached to the fibrous base, and thus has excellent heat resistance and weatherability in good productivity. Accordingly, when the inventive method for manufacturing a silicone resin transparent substrate is employed, it is possible to manufacture a silicone resin transparent substrate that can be used for a product required to be more flexible and more reliable.

Examples

Hereinafter, the present invention will be more specifically described by using Synthesis Examples, Comparative Synthesis Example, Examples, and Comparative Examples, but the present invention is not limited thereto. In the following examples, weight average molecular weights are measured by gel permeation chromatography (GPC) in terms of polystyrene.

[Synthesis Examples]

(Synthesis Example 1)

Synthesis of Organopolysiloxane (A-a)

Into toluene solvent, 952.5 g (81.6 mol%) of organosilane shown by $PhSiCl_3$, 398.0 g (9.1 mol%) of $ClMe_2SiO(Me_2SiO)_8SiMe_2Cl$, 37.8 g (4.8 mol%) of $MeViSiCl_2$, and 30.2 g (4.5 mol%) of $Me_2ViSiCl$ were dissolved. This solution was added to water dropwise, and subjected to co-hydrolysis, washing with water, neutralization by washing with alkali, and dehydration. Then, the solvent was stripped to synthesize Organopolysiloxane (A-a). This resin had a weight average molecular weight of 14,000.

(Synthesis Example 2)

Synthesis of Organopolysiloxane (A-b)

Into toluene solvent, 951.9 g (81.8 mol%) of organosilane shown by $PhSiCl_3$, 35.3 g (4.55 mol%) of $MeViSiCl_2$, and 30.2 g (4.55 mol%) of $Me_2ViSiCl$ were dissolved. The toluene solution was added dropwise to water dissolving 485.8 g (9.1 mol%) of $(MeO)MePhSiO(MePhSiO)_5SiMePh(OMe)$, and subjected to co-hydrolysis, washing with water, neutralization by washing with alkali, and dehydration. Then, the solvent was stripped to synthesize Organopolysiloxane (A-b). This resin had a weight average molecular weight of 9,600.

(Synthesis Example 3)

Synthesis of Organohydrogenpolysiloxane (B-a)

Into toluene solvent, 666.8 g (81.8 mol%) of organosilane shown by $PhSiCl_3$, 278.6 g (9.1 mol%) of $ClMe_2SiO(Me_2SiO)_8SiMe_2Cl$, and 40.3 g (9.1 mol%) of $MeHSiCl_2$ were dissolved. This solution was added to water dropwise, and subjected to co-hydrolysis, washing with water, neutralization by washing with alkali, and dehydration. Then, the solvent was stripped to synthesize Organohydrogenpolysiloxane (B-a). This resin had a weight average molecular weight of 11,000.

(Synthesis Example 4)

Synthesis of Organohydrogenpolysiloxane (B-b)

Into toluene solvent, 951.9 g (81.8 mol%) of organosilane shown by $PhSiCl_3$ and 57.5 g (9.1 mol%) of $MeHSiCl_2$ were dissolved. The toluene solution was added dropwise to water dissolving 485.8 g (9.1 mol%) of (MeO)MePh-SiO$(MePhSiO)_5$SiMePh(OMe), and subjected to co-hydrolysis, washing with water, neutralization by washing with alkali, and dehydration. Then, the solvent was stripped to synthesize Organohydrogenpolysiloxane (B-b). This resin had a weight average molecular weight of 14,000.

[Comparative Synthesis Example]

(Comparative Synthesis Example 1)

Synthesis of Alkoxysilane (D-a)

Into a flask, 198.3 g (1.00 mol) of phenyltrimethoxysilane (KBM-103, manufactured by Shin-Etsu Chemical Co., Ltd.) and 224.4 g (1.00 mol) of diphenyldimethoxysilane (KBM-202, manufactured by Shin-Etsu Chemical Co., Ltd.) were added as silicon atom-containing organic compounds, together with 600 g of isopropyl alcohol. Into the flask, a mixture of 14 g of 25% tetramethylammonium hydroxide (TMAH) and 128 g of water was added, followed by stirring for 3 hours. To this, 400 g of toluene was added, followed by washing with water and evaporating the solvent to synthesize Alkoxysilane (D-a). The obtained partial hydrolysis condensate of alkoxysilane (silicone resin) had a weight average molecular weight of 1,500.

[Examples and Comparative Examples]

(Example 1)

A base composition was obtained by mixing 95 g of Organopolysiloxane (A-a) obtained in Synthesis Example 1, 105 g of Organohydrogenpolysiloxane (B-a) obtained in Synthesis Example 3, 0.2 g of acetylene alcohol type ethynylmethyldecylcarbinol as a reaction inhibitor, and 0.2 g of 1% by mass octyl alcohol solution of chloroplatinic acid as a catalyst for addition reaction, followed by well-stirring. To this base composition, 60 g of toluene as a solvent was added, followed by stirring with a thinky mixer, to prepare a toluene dispersion of a silicone resin composition (S1).

A T-glass type glass cloth (manufactured by Nitto Boseki Co., Ltd.; thickness: 15 μm, refractive index: 1.52) was dipped into the toluene dispersion of the silicone resin composition (S1), and impregnated with the toluene dispersion of the silicone resin composition (S1) to give a prepreg. This prepreg was left at 80°C for 8 minutes to evaporate the toluene. The prepreg after evaporating toluene had films that were solid at room temperature and formed on both surfaces of the glass cloth.

Two pieces of the obtained prepregs were stacked on an ETFE resin film (trade name: AFLEX, manufactured by ASAHI GLASS CO., LTD.) which had been placed as a release sheet on a metal plate made of SUS installed on the thermal press molding apparatus shown in FIG. 1. A metal frame made of SUS with a thickness of 0.3 mm was installed so as to surround the prepreg-laminating region, and another release sheet and metal plate were installed on the upper side. Subsequently, press molding was performed at 160°C for 20 minutes, followed by at 200°C for 70 minutes by using the thermal press molding apparatus to give a silicone resin transparent substrate with a thickness of 0.3 mm.

(Example 2)

The same method as in Example 1 was repeated by using the toluene dispersion of the silicone resin composition (S1), except for using an E-glass type glass cloth (manufactured by Nitto Boseki Co., Ltd.; thickness: 15 μm, refractive index: 1.56) instead of the T-glass type glass cloth in Example 1, to give a silicone resin transparent substrate with a thickness of 0.3 mm.

(Example 3)

A toluene dispersion of a silicone resin composition (S2) was prepared by the same producing method as in Example 1 except for using 95 g of Organopolysiloxane (A-b) obtained in Synthesis Example 2 instead of the 95 g of Organopolysiloxane (A-a), and using 105 g of Organohydrogenpolysiloxane (B-b) obtained in Synthesis Example 4 instead of the 105 g of Organohydrogenpolysiloxane (B-a). This dispersion was used in the same manufacturing method

as in Example 1 to give a silicone resin transparent substrate with a thickness of 0.3 mm.

(Example 4)

The same method as in Example 3 was repeated by using the toluene dispersion of the silicone resin composition (S2), except for using an E-glass type glass cloth (manufactured by Nitto Boseki Co., Ltd.; thickness: 15 μm, refractive index: 1.56) instead of the T-glass type glass cloth in Example 3, to give a silicone resin transparent substrate with a thickness of 0.3 mm.

(Example 5)

The same method as in Example 3 was repeated by using the toluene dispersion of the silicone resin composition (S2), except for using a quartz glass cloth (manufactured by Shin-Etsu Quartz Products Co., Ltd.; thickness: 15 μm, refractive index: 1.45) instead of the T-glass type glass cloth in Example 3, to give a silicone resin transparent substrate with a thickness of 0.3 mm.

(Example 6)

A toluene dispersion of a silicone resin composition (S3) was prepared by the same method as in Example 4 except for using 90 g of toluene as the solvent. This was used for the same manufacturing method as in Example 4 to give a silicone resin transparent substrate with a thickness of 0.3 mm.

(Example 7)

A toluene dispersion of a silicone resin composition (S4) was prepared by the same method as in Example 4 except for using 75 g of toluene as the solvent. This was used for the same manufacturing method as in Example 4 to give a silicone resin transparent substrate with a thickness of 0.3 mm.

(Comparative Example 1)

The same method as in Example 1 was repeated by using the toluene dispersion of the silicone resin composition (S1) to give a prepreg composed of glass cloth impregnated with the silicone resin composition. Two pieces of the obtained prepregs were stacked on an ETFE resin film (trade name: AFLEX, manufactured by ASAHI GLASS Co., Ltd.) which had been placed as a release sheet on a metal plate made of SUS installed on the thermal press molding apparatus shown in FIG. 1. Another release sheet and metal plate were installed on the upper side thereof without installing a metal frame unlike in Example 1. Subsequently, press molding was performed at 160°C for 20 minutes, followed by at 200°C for 70 minutes by using the thermal press molding apparatus to give a silicone resin transparent substrate with a thickness of 0.15 mm.

(Comparative Example 2)

The same method as in Comparative Example 1 was repeated by using the toluene dispersion of the silicone resin composition (S1), except for using an E-glass type glass cloth (manufactured by Nitto Boseki Co., Ltd.; thickness: 15 μm, refractive index: 1.56) instead of the T-glass type glass cloth in Comparative Example 1, to give a silicone resin transparent substrate with a thickness of 0.15 mm.

(Comparative Example 3)

The toluene dispersion of the silicone resin composition (S2) was prepared by the same method as in Comparative Example 1 except for using 95 g of Organopolysiloxane (A-b) obtained in Synthesis Example 2 instead of the 95 g of Organopolysiloxane (A-a), and using 105 g of Organohydrogenpolysiloxane (B-b) obtained in Synthesis Example 4 instead of the 105 g of Organohydrogenpolysiloxane (B-a). This dispersion was used for the same manufacturing method as in Comparative Example 1 to give a silicone resin transparent substrate with a thickness of 0.15 mm.

(Comparative Example 4)

The same method as in Comparative Example 3 was repeated by using the toluene dispersion of the silicone resin composition (S2), except for using an E-glass type glass cloth (manufactured by Nitto Boseki Co., Ltd.; thickness:

15 μm, refractive index: 1.56) instead of the T-glass type glass cloth in Comparative Example 3, to give a silicone resin transparent substrate with a thickness of 0.15 mm.

(Comparative Example 5)

An E-glass type glass cloth (manufactured by Nitto Boseki Co., Ltd.; thickness: 15 μm, refractive index: 1.56) was dipped into Alkoxysilane (D-a) obtained in Comparative Synthesis Example 1, and impregnated with the alkoxysilane to give a prepreg. This prepreg was left at 80°C for 8 minutes. As a result, films that were solid at room temperature were formed on both surfaces of the glass cloth.

Two pieces of the obtained prepregs were stacked on an ETFE resin film (trade name: AFLEX, manufactured by ASAHI GLASS Co., Ltd.) which had been placed as a release sheet on a metal plate made of SUS installed on the thermal press molding apparatus shown in FIG. 1. A metal frame made of SUS with a thickness of 0.3 mm was installed so as to surround the prepreg-laminating region, and another release sheet and metal plate were installed on the upper side. Subsequently, press molding was performed at 160°C for 20 minutes, followed by at 200°C for 70 minutes by using the thermal press molding apparatus to give a silicone resin transparent substrate with a thickness of 0.3 mm.

The following measurements and evaluations were performed on the silicone resin transparent substrates obtained by Examples and Comparative Examples, the prepared silicone resin compositions, and Alkoxysilane (D-a) synthesized in Comparative Synthesis Example 1.

1. Evaluation of Heat Discoloration Resistance

To check the heat resistance of the silicone resin compositions (S1 to S4) used in Examples 1 to 7 and Comparative Examples 1 to 4, each of the silicone resin composition (S1 and S2) was applied on a glass plate so as to have a thickness of 1 mm, and then cured at 150°C for 4 hours to give a cured product. On the surface of the cured product of the silicone resin composition obtained on the glass plate, light transmittance before heat treatment was measured at the average wavelength of blue LED (450 nm) with a spectrophotometer U-4100 (manufactured by Hitachi Co., Ltd.). Subsequently, heat treatment at 200°C for 100 hours was performed on the glass plate on which the cured product of the silicone resin composition had been formed. Then, light transmittance after heat treatment was measured in the same manner as before heat treatment. The results are shown in Table 1.

2. Measurement of Refractive Index of Silicone Resin Composition

The refractive index was measured on the silicone resin compositions (S1 to S4) and Alkoxysilane (D-a) used in Examples 1 to 7 and Comparative Examples 1 to 5 in conformity with the method disclosed in JIS K 0062:1992. The apparatus used for measuring was a digital refractometer RX-9000α (manufactured by ATAGO Co., Ltd.). The results are shown in Table 2 and Table 3.

3. Measurement of Attached Amount of Silicone Resin Composition to Fibrous Base in Silicone Resin Transparent Substrate

The attached amount of the silicone resin compositions (or the alkoxysilane) was determined on the silicone resin transparent substrates obtained in Examples 1 to 7 and Comparative Examples 1 to 5 based on the following numerical formula 1 by using the difference between the weight of the glass cloth (the fibrous base) and the weight of silicone resin transparent substrate after press molding. The results are shown in Table 2 and Table 3.

$$\text{Attached amount of silicone resin composition (mass\%)} = ((\text{mass of silicone resin transparent substrate (g)} - \text{mass of fibrous base (g)}) / \text{mass of silicone resin transparent substrate (g)}) \times 100 \quad \text{(Numerical Formula 1)}$$

4. Measurement of Total Light Transmittance

The total light transmittance at 450 nm was measured on the silicone resin transparent substrates obtained in Examples 1 to 7 and Comparative Examples 1 to 5 in conformity with JIS K 7375:2008 by using a spectrophotometer

U-4100 (manufactured by Hitachi Co., Ltd.) and an integrating sphere. The results are shown in Table 2 and Table 3.

5. Measurement of Water Vapor Permeability

The water vapor permeability was measured on the silicone resin transparent substrates obtained in Examples 1 to 7 and Comparative Examples 1 to 5 by Lyssy method in conformity with JIS K 7129:2008 using L80-5000 manufactured by Lyssy Co. The results are shown in Table 2 and Table 3.

6. Evaluation of Flexibility

A test piece with a size of 5 mm × 100 mm was cut out from each of the silicone resin transparent substrates obtained in Examples 1 to 7 and Comparative Examples 1 to 5. As shown in FIG. 4, one of the short side of the test piece 15 of the silicone resin transparent substrate was fixed with a supporting jig 14 of a test bench. A cylindrical metal bar 16 with a radius of 3 mm was set at the central position of the long side across the test piece 15 parallel with the short side. The test piece 15 was bent, with the free end of the other short side turning to 180° along the cylindrical metal bar 16 as shown by the arrow in FIG. 4. Then, the test piece 15 bent into 180° along the cylindrical metal bar was moved as shown by the arrow in FIG. 5 so as to return to horizontal as shown in FIG. 4. These operations were repeated for 10 times to evaluate the flexibility by bend test to check whether a bent crease or delamination of the silicone resin composition was observed or not. Subsequently, the silicone resin transparent substrate was subjected to heat treatment at 200°C for 100 hours, and then the bend test was performed as before heat treatment to evaluate the flexibility. The results are shown in Table 2 and Table 3.

[Table 1]

| | | S1 | S2 |
|---|---|---|---|
| Light transmittance at 450 nm wavelength (%) | Before heat treatment | 100 | 98 |
| | After heat treatment | 98 | 97 |

As shown in Table 1, both of the silicone resin compositions (S1 and S2) were excellent in heat resistance.

[Table 2]

| | | Example 1 | Example 2 | Example 3 | Example 4 | Example 5 | Example 6 | Example 7 |
|---|---|---|---|---|---|---|---|---|
| Refractive index of fibrous base | | 1.52 | 1.56 | 1.52 | 1.56 | 1.45 | 1.56 | 1.56 |
| Refractive index of silicone resin composition | | 1.52 | 1.52 | 1.57 | 1.57 | 1.57 | 1.57 | 1.57 |
| Attached amount of silicone resin composition (mass%) | | 94 | 91 | 90 | 88 | 87 | 63 | 72 |
| Total light transmittance (%) | | 92 | 91 | 90 | 91 | 82 | 83 | 88 |
| Water vapor permeability ($g/m^2 \cdot day$) | | 44 | 44 | 47 | 50 | 49 | 59 | 58 |
| Flexibility*1 | Before heat treatment | Good | Good | Good | Good | Good | Good | Good |
| | After heat treatment | Good | Good | Good | Good | Good | Good | Good |
| *1 flexibility:<br>Good: No problem occurred in appearance after bend test.<br>Poor: Bent crease or delamination of resin was observed after bend test. | | | | | | | | |

[Table 3]

| | | Comparative Example 1 | Comparative Example 2 | Comparative Example 3 | Comparative Example 4 | Comparative Example 5 |
|---|---|---|---|---|---|---|
| Refractive index of fibrous base | | 1.52 | 1.56 | 1.52 | 1.56 | 1.56 |
| Refractive index of silicone resin composition | | 1.52 | 1.52 | 1.57 | 1.57 | 1.55 |
| Attached amount of silicone resin composition (mass%) | | 53 | 50 | 56 | 53 | 79 |
| Total light transmittance (%) | | 75 | 71 | 71 | 76 | 89 |
| Water vapor permeability ($g/m^2 \cdot day$) | | 57 | 54 | 60 | 56 | 51 |
| Flexibility*2 | Before heat treatment | Good | Good | Good | Good | Good |
| | After heat treatment | Good | Good | Good | Good | Poor |
| *2 flexibility:<br>Good: No problem occurred in appearance after bend test.<br>Poor: Bent crease or delamination of resin was observed after bend test. | | | | | | |

As shown in Table 2, when the silicone resin transparent substrate was manufactured by the inventive manufacturing method, the attached amount of the silicone resin composition could be retained to 60% by mass or more and 99% by mass or less. Examples 1 to 7, which correspond to the inventive silicone resin transparent substrates that retained high attached amount, showed high transparency as the total light transmittance was high value of 80% or more, excellent weatherability having low moisture permeability as the water vapor permeability was 65 $g/m^2 \cdot day$ or less, as well as good heat resistance and flexibility. In particular, Examples 1 to 5 showed much lower moisture permeability as the water vapor permeability was 50 $g/m^2 \cdot day$ or less.

On the other hand, as shown in Table 3, Comparative Examples 1 to 4, which did not use the inventive manufacturing method and thus had low attached amount of the silicone resin composition, showed lower total light transmittance although the flexibility was retained to some extent, thus failing to manufacture a silicone resin transparent substrate with both of flexibility and high transparency. In Comparative Example 5, using the alkylsilane of a condensation type silicone resin (i.e. using the silicone resin itself instead of the silicone resin composition), the attached amount of resin was large, and the total light transmittance and the water vapor permeability were good. However, this resin had poor curability, and thus failed to complete the reaction when the substrate was manufactured by the same method as in the inventive silicone resin transparent substrate. This reaction proceeded in heat treatment after molding and made the resin brittle, reducing the flexibility of the substrate. Accordingly, a silicone resin transparent substrate with high reliability could not be obtained.

As described above, it was found that the inventive manufacturing method makes it possible to manufacture a silicone resin transparent substrate with large amount of the attached silicone resin composition. It was also found that the inventive silicone resin transparent substrate, having large amount of the attached silicone resin composition, can be a highly reliable silicone resin transparent substrate with flexibility, high transparency, and low moisture permeability.

It is to be noted that the present invention is not restricted to the foregoing embodiment. The embodiment is just an exemplification, and any examples that have substantially the same feature and demonstrate the same functions and effects as those in the technical concept described in claims of the present invention are included in the technical scope of the present invention.

## Claims

1. A silicone resin transparent substrate, comprising one or more than one prepreg containing a silicone resin composition containing no filler and a fibrous base, wherein the silicone resin transparent substrate has: an attached amount of the silicone resin composition to the fibrous base of 60% by mass or more and 99% by mass or less determined by the following numerical formula 1; a total light transmittance of 80% or more at 450 nm, as measured by a method disclosed in JIS K 7375:2008 in a thickness of 0.1 mm to 0.4 mm; and a water vapor permeability of 65 $g/m^2 \cdot day$ or less, as measured by Lyssy method in conformity with JIS K 7129:2008 in a thickness of 0.1 mm to 0.4 mm;

$$\text{attached amount of silicone resin composition to fibrous base (mass\%)} = ((\text{mass of silicone resin transparent substrate (g)} - \text{mass of fibrous base (g)})/\text{mass of silicone resin transparent substrate (g)}) \times 100 \quad \text{(Numerical Formula 1)}$$

2. The silicone resin transparent substrate according to claim 1, wherein the silicone resin composition contains:

(A) an organopolysiloxane shown by the following average composition formula (1) having two or more silicon atom-bonded alkenyl groups in one molecule,

$$(R^1_3SiO_{1/2})_a(R^1_2SiO_{2/2})_b(R^1SiO_{3/2})_c(SiO_{4/2})_d \qquad (1)$$

wherein $R^1$ independently represents a hydroxy group, a methoxy group, an ethoxy group, a saturated monovalent hydrocarbon group having 1 to 10 carbon atoms, a monovalent aromatic hydrocarbon group, or an alkenyl group having 2 to 10 carbon atoms; and "a", "b", "c", and "d" are numbers satisfying $a \geq 0$, $b \geq 0$, $c \geq 0$, $0 \geq 0$, $a+b+c+d=1$, and $0<(c+d) \leq 1.0$;
(B) an organohydrogenpolysiloxane having two or more silicon atom-bonded hydrogen atoms in one molecule, with the silicon atom-bonded hydrogen atoms in the component (B) being in an amount of 0.1 to 5.0 mol per one mol of the silicon atom-bonded alkenyl groups in the component (A); and
(C) a platinum group metal catalyst.

3. The silicone resin transparent substrate according to claim 1 or claim 2, wherein the silicone resin composition is in a solid state at 25°C.

4. The silicone resin transparent substrate according to any one of claims 1 to 3, wherein a difference in reflective index between the silicone resin composition and the fibrous base is 0.15 or less.

5. A method for manufacturing a silicone resin transparent substrate, comprising press molding to integrate a prepreg containing a silicone resin composition containing no filler and a fibrous base or a plurality of the prepregs that are stacked, wherein the silicone resin transparent substrate has a total light transmittance of 80% or more at 450 nm, as measured by a method disclosed in JIS K 7375:2008 in a thickness of 0.1 mm to 0.4 mm, wherein the press molding is performed by using a metal frame installed so as to surround a prepreg-laminating region for laminating the prepreg to manufacture the silicone resin transparent substrate with an attached amount of the silicone resin composition to the fibrous base being 60% by mass or more and 99% by mass or less;

$$\text{attached amount of silicone resin composition to fibrous base (mass\%)} = ((\text{mass of silicone resin transparent substrate (g)} - \text{mass of fibrous base (g)})/\text{mass of silicone resin transparent substrate (g)}) \times 100 \quad \text{(Numerical Formula 1)}$$

6. The method for manufacturing a silicone resin transparent substrate according to claim 5, wherein the silicone resin composition contains:

(A) an organopolysiloxane shown by the following average composition formula (1) having two or more silicon atom-bonded alkenyl groups in one molecule,

$$(R^1{}_3SiO_{1/2})_a(R^1{}_2SiO_{2/2})_b(R^1SiO_{3/2})_c(SiO_{4/2})_d \quad (1)$$

wherein $R^1$ independently represents a hydroxy group, a methoxy group, an ethoxy group, a saturated monovalent hydrocarbon group having 1 to 10 carbon atoms, a monovalent aromatic hydrocarbon group, or an alkenyl group having 2 to 10 carbon atoms; and "a", "b", "c", and "d" are numbers satisfying a≥0, 0≥0, c≥0, 0≥0, a+b+c+d=1, and 0<(c+d)<1.0;

(B) an organohydrogenpolysiloxane having two or more silicon atom-bonded hydrogen atoms in one molecule, with the silicon atom-bonded hydrogen atoms in the component (B) being in an amount of 0.1 to 5.0 mol per one mol of the silicon atom-bonded alkenyl groups in the component (A); and

(C) a platinum group metal catalyst.

7. The method for manufacturing a silicone resin transparent substrate according to claim 5 or claim 6, wherein the silicone resin composition is in a solid state at 25°C.

8. The method for manufacturing a silicone resin transparent substrate according to any one of claims 5 to 7, wherein a difference in reflective index between the silicone resin composition and the fibrous base is 0.15 or less.

**Patentansprüche**

1. Transparentes Silikon-Kunststoffsubstrat, umfassend einen oder mehrere als einen Prepreg, enthaltend eine Silikon-Kunststoffzusammensetzung, die keinen Füllstoff enthält und eine faserförmige Basis,
wobei das transparente Silikon-Kunststoffsubstrat hat: eine anhängende Menge der Silikon-Kunststoffzusammensetzung an die faserförmige Basis von 60 Massen-% oder darüber und 99 Massen-% oder weniger, bestimmt durch die folgende numerische Formel 1; eine Gesamtlichttransmission von 80 % oder darüber bei 450 nm, wie gemessen durch ein Verfahren, offenbart in JIS K 7375:2008, bei einer Dicke von 0,1 mm bis 0,4 mm; und eine Wasserdampfpermeabilität von 65 g/m$^2$·Tag oder darunter, wie gemessen durch eine Lyssy-Methode entsprechend JIS K7129:2008, bei einer Dicke von 0,1 mm bis 0,4 mm;

anhängende Menge an Silikon-Kunststoffzusammensetzung zu faserförmiger Basis (Massen-%) = ((Masse des transparenten Silikon-Kunststoffsubstrats (g) – Masse der faserförmigen Basis (g)) / Masse des transparenten Silikon-Kunststoffsubstrats (g)) x 100 (Numerische Formel 1).

2. Transparentes Silikon-Kunststoffsubstrat gemäß Anspruch 1, wobei die Silikon-Kunststoffzusammensetzung enthält:

(A) ein durch die folgende durchschnittliche Zusammensetzungsformel (1) gezeigtes Organopolysiloxan mit zwei oder mehreren Siliziumatom-gebundenen Alkenylgruppen in einem Molekül,

$$(R^1{}_3SiO_{1/2})_a(R^1{}_2SiO_{2/2})_b(R^1SiO_{3/2})_c(SiO_{4/2})_d \quad (1),$$

worin $R^1$ unabhängig für eine Hydroxygruppe, eine Methoxygruppe, eine Ethoxygruppe, eine gesättigte monovalente Kohlenwasserstoffgruppe mit 1 bis 10 Kohlenstoffatomen, eine monovalente aromatische Kohlenwasserstoffgruppe oder eine Alkenylgruppe mit 2 bis 10 Kohlenstoffatomen steht; und "a", "b", "c" und "d" sind Zahlen, die genügen a≥0, b≥0, c≥0, d≥0, a+b+c+d=1 und 0<(c+d)≤1.0;

(B) ein Organowasserstoffpolysiloxan mit zwei oder mehreren Siliziumatom-gebundenen Wasserstoffatomen in einem Molekül, wobei die Siliziumatom-gebundenen Wasserstoffatome in der Komponente (B) in einer Menge von 0,1 bis 5,0 Mol pro Mol der Siliziumatom-gebundenen Alkenylgruppen in der Komponente (A) sind; und

(C) einen Metallkatalysator aus der Platingruppe.

3. Transparentes Silikon-Kunststoffsubstrat gemäß Anspruch 1 oder Anspruch 2, wobei die Silikon-Kunststoffzusammensetzung in festem Zustand bei 25°C ist.

4. Transparentes Silikon-Kunststoffsubstrat gemäß irgendeinem der Ansprüche 1 bis 3, wobei eine Differenz des

Reflektionsindex zwischen der Silikon-Kunststoffzusammensetzung und der faserförmigen Basis 0,15 oder darunter ist.

**5.** Verfahren zur Herstellung eines transparenten Silikon-Kunststoffsubstrats, umfassend das Druckverformen, um ein Prepreg zu integrieren, das eine Silikon-Kunststoffzusammensetzung ohne Füllstoff und eine faserförmige Basis enthält oder eine Vielzahl von aufeinander gestapelten Prepregs, wobei das transparente Silikon-Kunststoffsubstrat eine Gesamtlichttransmission von 80 % oder darüber bei 450 nm hat, wie gemessen durch ein Verfahren, offenbart in JIS K 7375:2008, bei einer Dicke von 0,1 mm bis 0,4 mm,
wobei das Druckverformen unter Verwendung eines Metallrahmens durchgeführt ist, der so installiert ist, dass er eine Prepreg-Laminierregion umgibt, um das Prepreg zu laminieren, um das transparente Silikon-Kunststoffsubstrat herzustellen, mit einer anhängenden Menge der Silikon-Kunststoffzusammensetzung zur faserförmigen Basis von 60 Masse-% oder darüber und 99 Massen-% oder darunter;

anhängende Menge an Silikon-Kunststoffzusammensetzung zu faserförmiger Basis (Massen-%) = ((Masse des transparenten Silikon-Kunststoffsubstrats (g) – Masse der faserförmigen Basis (g)) / Masse des transparenten Silikon-Kunststoffsubstrats (g)) x 100 (Numerische Formel 1).

**6.** Verfahren zur Herstellung eines transparenten Silikon-Kunststoffsubstrats gemäß Anspruch 5, wobei die Silikon-Kunststoffzusammensetzung enthält:

(A) ein durch die folgende durchschnittliche Zusammensetzungsformel (1) gezeigtes Organopolysiloxan mit zwei oder mehreren Siliziumatom-gebundenen Alkenylgruppen in einem Molekül,

$$(R^1{}_3SiO_{1/2})_a(R^1{}_2SiO_{2/2})_b(R^1SiO_{3/2})_c(SiO_{4/2})_d \qquad (1),$$

worin $R^1$ unabhängig für eine Hydroxygruppe, eine Methoxygruppe, eine Ethoxygruppe, eine gesättigte monovalente Kohlenwasserstoffgruppe mit 1 bis 10 Kohlenstoffatomen, eine monovalente aromatische Kohlenwasserstoffgruppe oder eine Alkenylgruppe mit 2 bis 10 Kohlenstoffatomen steht; und "a", "b", "c" und "d" sind Zahlen, die genügen $a \geq 0$, $0 \geq 0$, $c \geq 0$, $0 \geq 0$, $a+b+c+d=1$ und $0<(c+d) \leq 1.0$;
(B) ein Organowasserstoffpolysiloxan mit zwei oder mehreren Siliziumatom-gebundenen Wasserstoffatomen in einem Molekül, wobei die Siliziumatom-gebundenen Wasserstoffatome in der Komponente (B) in einer Menge von 0,1 bis 5,0 Mol pro Mol der Siliziumatom-gebundenen Alkenylgruppen in der Komponente (A) sind; und
(C) einen Metallkatalysator aus der Platingruppe.

**7.** Verfahren zur Herstellung eines transparenten Silikon-Kunststoffsubstrats gemäß Anspruch 5 oder Anspruch 6, wobei die Silikon-Kunststoffzusammensetzung bei 25°C in einem festen Zustand ist.

**8.** Verfahren zur Herstellung eines transparenten Silikon-Kunststoffsubstrats gemäß irgendeinem der Ansprüche 5 bis 7, wobei eine Differenz des Reflektionsindex zwischen der Silikon-Kunststoffzusammensetzung und der faserförmigen Basis 0,15 oder darunter ist.

## Revendications

**1.** Substrat transparent en résine de silicone, comprenant un ou plus d'un préimprégné contenant une composition de résine de silicone ne contenant pas de charge et une base fibreuse, dans lequel le substrat transparent en résine de silicone a : une quantité liée de la composition de résine de silicone à la base fibreuse de 60 % en masse ou plus et de 99 % en masse ou moins déterminée par la formule numérique 1 suivante ; une transmittance de la lumière totale de 80 % ou plus à 450 nm, telle que mesurée par un procédé décrit dans la norme JIS K 7375 : 2008, dans une épaisseur de 0,1 mm à 0,4 mm ; et une perméabilité à la vapeur d'eau de 65 $g/m^2 \cdot$jour ou moins, telle que mesurée par la méthode Lyssy conformément à la norme JIS K 7129 : 2008, dans une épaisseur de 0,1 mm à 0,4 mm ;

quantité liée de composition de résine de silicone à la base fibreuse (% en masse) = ((masse de substrat transparent en résine de silicone (g) - masse de base fibreuse (g))/masse de substrat transparent en résine de silicone (g)) x 100 (Formule numérique 1).

2. Substrat transparent en résine de silicone selon la revendication 1, dans lequel la composition de résine de silicone contient :

(A) un organopolysiloxane représenté par la formule de composition moyenne (1) suivante ayant deux groupes alcényle liés à un atome de silicium ou plus dans une molécule,

$$(R^1{}_3SiO_{1/2})_a(R^1{}_2SiO_{2/2})_b(R^1SiO_{3/2})_c(SiO_{4/2})_d \qquad (1)$$

dans laquelle $R^1$ représente indépendamment un groupe hydroxy, un groupe méthoxy, un groupe éthoxy, un groupe hydrocarboné monovalent saturé ayant 1 à 10 atomes de carbone, un groupe hydrocarboné aromatique monovalent ou un groupe alcényle ayant 2 à 10 atomes de carbone ; et « a », « b », « c » et « d » sont des nombres satisfaisant $a \geq 0$, $b \geq 0$, $c \geq 0$, $d \geq 0$, $a + b + c + d = 1$, et $0 < (c + d) \leq 1,0$ ;
(B) un organohydrogénopolysiloxane ayant deux atomes d'hydrogène liés à un atome de silicium ou plus dans une molécule, avec les atomes d'hydrogène liés à un atome de silicium dans le composant (B) étant en une quantité de 0,1 à 5,0 moles pour une mole de groupes alcényle liés à un atome de silicium dans le composant (A) ; et
(C) un catalyseur à base de métal du groupe du platine.

3. Substrat transparent en résine de silicone selon la revendication 1 ou la revendication 2, dans lequel la composition de résine de silicone est à l'état solide à 25 °C.

4. Substrat transparent en résine de silicone selon l'une quelconque des revendications 1 à 3, dans lequel une différence d'indice de réflexion entre la composition de résine de silicone et la base fibreuse est de 0,15 ou moins.

5. Procédé de fabrication d'un substrat transparent en résine de silicone, comprenant un moulage par compression pour intégrer un préimprégné contenant une composition de résine de silicone ne contenant pas de charge et une base fibreuse ou une pluralité de préimprégnés qui sont empilés, dans lequel le substrat transparent en résine de silicone a une transmittance de la lumière totale de 80 % ou plus à 450 nm, telle que mesurée par un procédé décrit dans la norme JIS K 7375 : 2008, dans une épaisseur de 0,1 mm à 0,4 mm,
dans lequel le moulage par compression est effectué en utilisant un cadre métallique installé de manière à entourer une région de stratification de préimprégné pour stratifier le préimprégné afin de fabriquer le substrat transparent en résine de silicone avec une quantité liée de la composition de résine de silicone à la base fibreuse étant de 60 % en masse ou plus et de 99 % en masse ou moins ;

quantité liée de composition de résine de silicone à la base fibreuse (% en masse) = ((masse de substrat transparent en résine de silicone (g) - masse de base fibreuse (g))/masse de substrat transparent en résine de silicone (g)) x 100 (Formule numérique 1)

6. Procédé de fabrication d'un substrat transparent en résine de silicone selon la revendication 5, dans lequel la composition de résine de silicone contient :

(A) un organopolysiloxane représenté par la formule de composition moyenne (1) suivante ayant deux groupes alcényle liés à un atome de silicium ou plus dans une molécule,

$$(R^1{}_3SiO_{1/2})_a(R^1{}_2SiO_{2/2})_b(R^1SiO_{3/2})_c(SiO_{4/2})_d \qquad (1)$$

dans laquelle $R^1$ représente indépendamment un groupe hydroxy, un groupe méthoxy, un groupe éthoxy, un groupe hydrocarboné monovalent saturé ayant 1 à 10 atomes de carbone, un groupe hydrocarboné aromatique monovalent ou un groupe alcényle ayant 2 à 10 atomes de carbone ; et « a », « b », « c » et « d » sont des nombres satisfaisant $a \geq 0$, $b \geq 0$, $c \geq 0$, $d \geq 0$, $a + b + c + d = 1$, et $0 < (c + d) \leq 1,0$ ;
(B) un organohydrogénopolysiloxane ayant deux atomes d'hydrogène liés à un atome de silicium ou plus dans une molécule, avec les atomes d'hydrogène liés à un atome de silicium dans le composant (B) étant en une quantité de 0,1 à 5,0 moles pour une mole de groupes alcényle liés à un atome de silicium dans le composant (A) ; et
(C) un catalyseur à base de métal du groupe du platine.

**7.** Procédé de fabrication d'un substrat transparent en résine de silicone selon la revendication 5 ou la revendication 6, dans lequel la composition de résine de silicone est à l'état solide à 25 °C.

**8.** Procédé de fabrication d'un substrat transparent en résine de silicone selon l'une quelconque des revendications 5 à 7, dans lequel une différence d'indice de réflexion entre la composition de résine de silicone et la base fibreuse est de 0,15 ou moins.

FIG. 1

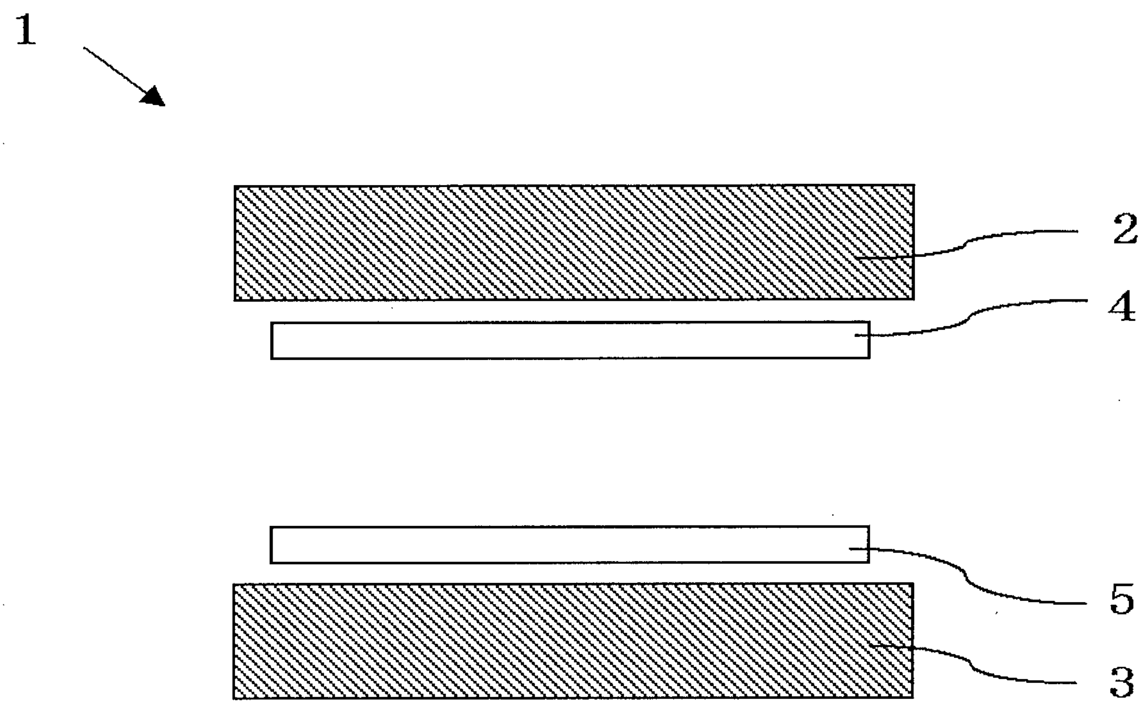


FIG. 2

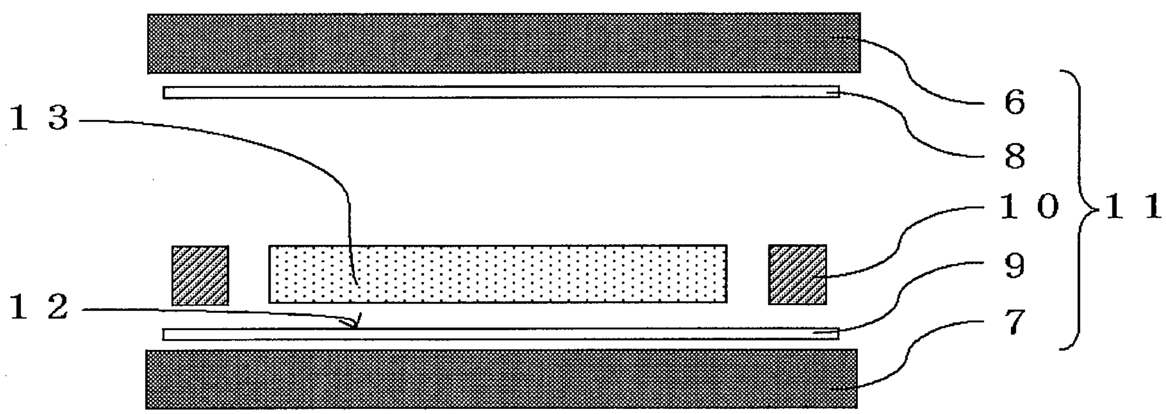

FIG. 3

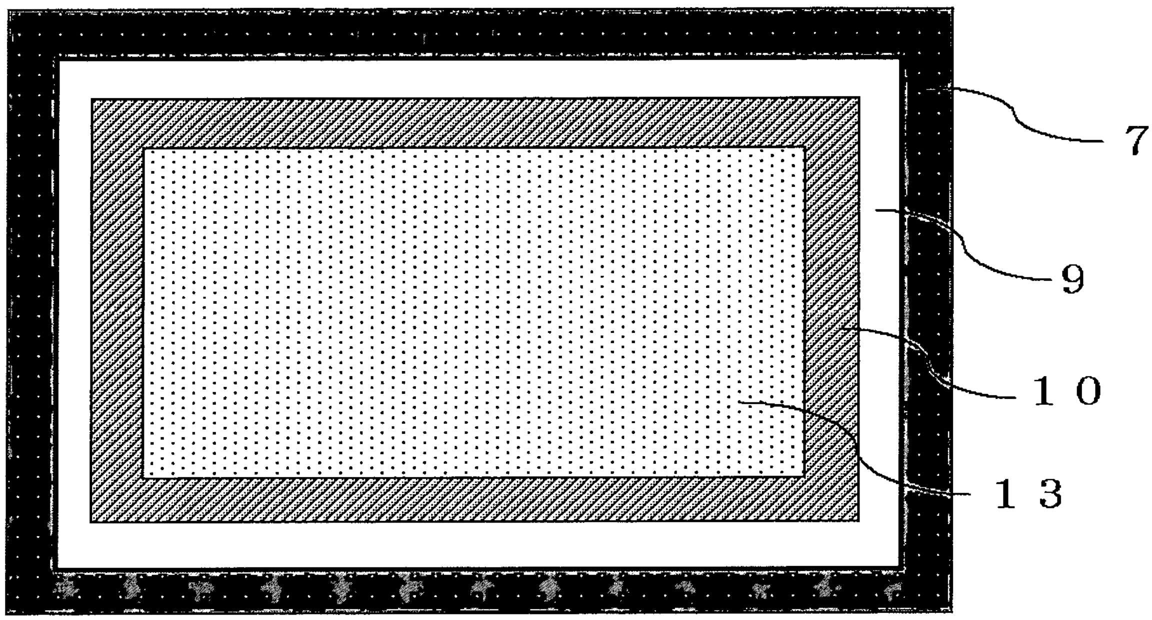


FIG. 4

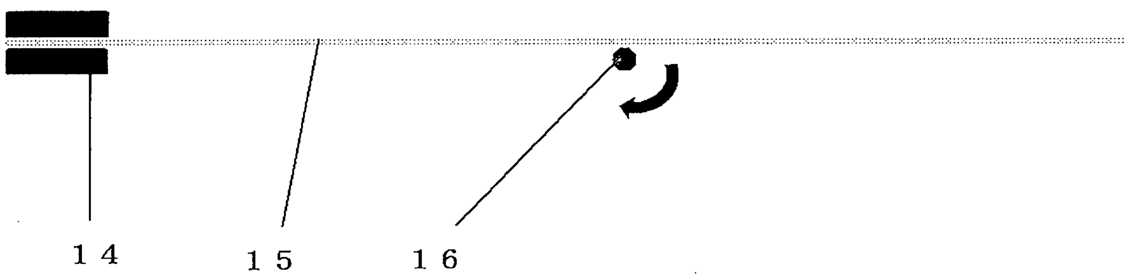


FIG. 5

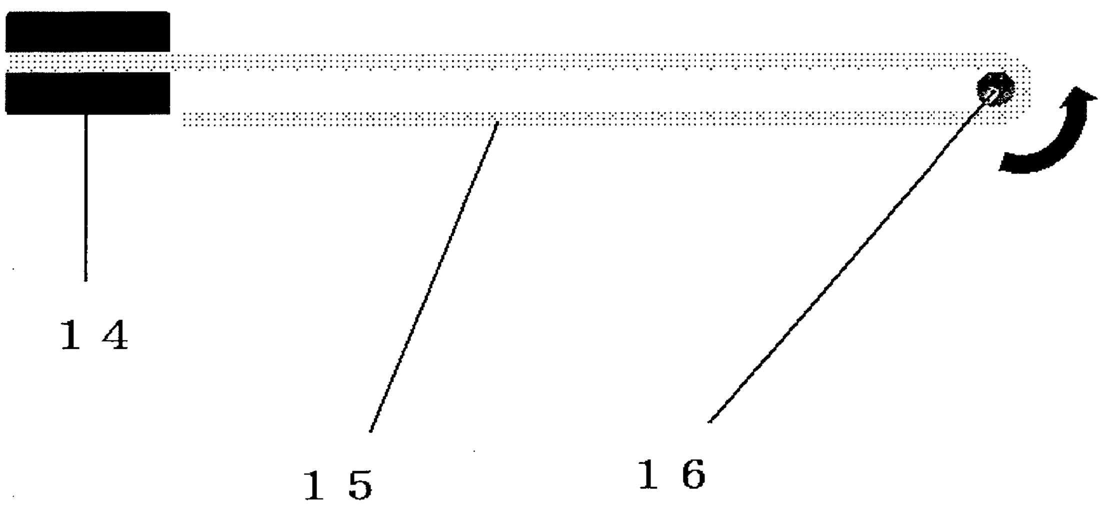

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2012064534 A
- JP 2004051960 A
- JP 2015174937 A